# EUROPEAN PATENT APPLICATION

(11) **EP 4 746 040 A1**
(43) Date of publication of application: **20.05.2026**
(21) Application number: 24890553.1
(22) Date of filing: 06.11.2024
(51) Int. Cl.: H01L 23/367, H01L 23/552, H10B 80/00, H05K 1/02

(54) **PACKAGE ASSEMBLY AND ELECTRONIC DEVICE**

(30) Priority: 16.11.2023 CN 202311532597; 15.01.2024 CN 202410057866
(71) Applicant: Huawei Technologies Co., Ltd., Shenzhen, Guangdong 518129 (CN)
(72) Inventor: YANG, Jiangtao, Shenzhen, Guangdong 518129 (CN); LU, Lin, Shenzhen, Guangdong 518129 (CN); WANG, Yuchuan, Shenzhen, Guangdong 518129 (CN); PAN, Jiao, Shenzhen, Guangdong 518129 (CN); HENG, Fei, Shenzhen, Guangdong 518129 (CN); LIANG, Tenghe, Shenzhen, Guangdong 518129 (CN)
(74) Representative: Thun, Clemens
(86) International application number: PCT/CN2024/130341
(87) International publication number: WO 2025/103196

(57) **Abstract**

Embodiments of this application relate to the field of electronic device technologies, and provide a package assembly and an electronic device. The package assembly of the electronic device is mounted on a circuit board of the electronic device. A thermal conduction pillar is disposed, where thermal conduction between one end of the thermal conduction pillar and a heat dissipation apparatus and thermal conduction between other end of the thermal conduction pillar and a chip that is in the package assembly and that is close to the circuit board are implemented. In this case, the chip that is in the package assembly and that is close to the circuit board can transfer heat to the heat dissipation apparatus via the thermal conduction pillar for heat dissipation. In this way, the chip that is in the package assembly and that is close to the circuit board has high heat dissipation efficiency, thereby helping improve heat dissipation efficiency of the entire package assembly.

## Description

This application claims priorities to Chinese Patent Application No. 202311532597.X, filed with the China National Intellectual Property Administration on November 16, 2023 and entitled "PACKAGE ASSEMBLY AND ELECTRONIC DEVICE", and to Chinese Patent Application No. 202410057866.X, filed with the China National Intellectual Property Administration on January 15, 2024 and entitled "PACKAGE ASSEMBLY AND ELECTRONIC DEVICE", both of which are incorporated herein by reference in their entireties.

### TECHNICAL FIELD

Embodiments of this application relate to the field of electronic device technologies, and in particular, to a package assembly and an electronic device.

### BACKGROUND

An electronic device like a mobile phone, a tablet computer, or a notebook computer may include a package assembly, a printed circuit board (printed circuit board, PCB), and a heat dissipation apparatus. The package assembly is mounted on the printed circuit board and is located between the printed circuit board and the heat dissipation apparatus. The package assembly may dissipate heat via the heat dissipation apparatus.

Package on package (package on package, POP) is a chip packaging method in which two or more chips are stacked to form a package assembly including a plurality of vertically distributed chip layers. In a related technology, a package assembly formed through package on package may include at least two chips stacked up and down, a lower surface of a bottommost chip is mounted on a circuit board, and an upper surface of a topmost chip is used to perform heat exchange with a heat dissipation apparatus.

However, in the related technology, the package assembly formed through package on package has low heat dissipation efficiency, resulting in limited performance of the package assembly formed through package on package.

### SUMMARY

Embodiments of this application provide a package assembly and an electronic device, to improve heat dissipation efficiency of the package assembly, and reduce a limitation on performance of the package assembly caused by low heat dissipation efficiency.

A first aspect of this application provides a package assembly, including a first chip, a second chip, and a thermal conduction pillar. The second chip is disposed on one side of the first chip in a thickness direction, and the other side of the first chip in the thickness direction is configured to be connected to a first circuit board. The second chip is configured to be connected to a heat dissipation apparatus disposed on one side that is of the second chip and that is away from the first chip, so that the second chip is configured for thermal conduction with the heat dissipation apparatus. The first chip has a first connection part, and a projection of the first connection part in the thickness direction of the first chip is located outside a projection of the second chip in the thickness direction of the first chip. One end of the thermal conduction pillar is connected to the first connection part, to implement thermal conduction between the thermal conduction pillar and the first chip; and the other end of the thermal conduction pillar protrudes from a surface of one side that is of the first chip and that faces the second chip, and is configured to be connected to the heat dissipation apparatus, to implement thermal conduction between the thermal conduction pillar and the heat dissipation apparatus.

According to the package assembly provided in embodiments of this application, the thermal conduction pillar is connected to the heat dissipation apparatus to form a heat dissipation path of the first chip, so that heat generated by the first chip can be transferred to the heat dissipation apparatus via the thermal conduction pillar for heat dissipation. Compared with that in a heat dissipation path in which the first chip transfers the heat to the heat dissipation apparatus via the second chip, the thermal conduction pillar has lower thermal resistance. Compared with the first circuit board, the heat dissipation apparatus has higher heat dissipation efficiency, and therefore the first chip has higher heat dissipation efficiency. This helps improve heat dissipation efficiency of the package assembly, and can further reduce a limitation on performance of the package assembly caused by low heat dissipation efficiency.

Specifically, the first chip includes a second circuit board and a die. The die is disposed on one side of the second circuit board in a thickness direction, the other side of the second circuit board in the thickness direction is configured to be connected to the first circuit board, and the second chip is disposed on one side that is of the die and that is away from the second circuit board.

In a possible implementation, the second circuit board has a first thermal conduction sheet, and the first thermal conduction sheet has the first connection part and a second connection part. A projection of the first connection part in the thickness direction of the second circuit board is located outside a projection of the die in the thickness direction of the second circuit board. A projection of the second connection part in the thickness direction of the second circuit board is located inside the projection of the die in the thickness direction of the second circuit board. The thermal conduction pillar is connected to the first thermal conduction sheet, to implement thermal conduction between the thermal conduction pillar and the first thermal conduction sheet, and the second connection part is connected to the die, to implement thermal conduction between the first thermal conduction sheet and the die. In this way, heat generated by the die can be transferred to the heat dissipation apparatus via the first thermal conduction sheet and the thermal conduction pillar for heat dissipation, so that heat dissipation efficiency of the die is high. In addition, the thermal conduction pillar is connected to the second circuit board, so that the thermal conduction pillar is easily connected. In addition, the thermal conduction pillar is disposed without affecting packaging of the die, so that a package structure configured to protect the die is disposed on a surface of the die.

The first thermal conduction sheet may be a metal sheet formed by a metal layer of the second circuit board. For example, the first thermal conduction sheet may be a copper sheet.

In a possible implementation, one side that is of the die and that faces the second circuit board includes a first electrical connection region, and a projection of the first electrical connection region in the thickness direction of the second circuit board is located outside a projection of the first thermal conduction sheet in the thickness direction of the second circuit board. A first power terminal and a first signal terminal are disposed on the side that is of the die and that faces the second circuit board, the first power terminal and the first signal terminal are both located inside the first electrical connection region, and the die is electrically connected to the second circuit board via the first power terminal and the first signal terminal. A first thermal conduction structure is disposed between the die and the second connection part, and the die is connected to the second connection part via the first thermal conduction structure, to implement thermal conduction between the die and the first thermal conduction sheet via the first thermal conduction structure. In this way, the die is electrically connected to the second circuit board having the first thermal conduction sheet, and the first thermal conduction sheet has small impact on current and signal transmission between the second circuit board and the die. In addition, the first power terminal and the first signal terminal are both disposed outside an overlapping region between the die and the first thermal conduction sheet. This facilitates arrangement of a finished first thermal conduction sheet with a large size and good integrity, so that thermal conduction efficiency of the first thermal conduction sheet is high.

The first power terminal is a terminal for power supply between the die and the second circuit board, and the first signal terminal is a terminal for signal transmission between the die and the second circuit board.

In a possible implementation, the first thermal conduction sheet is made of a conductive material, the first thermal conduction structure includes a first ground terminal disposed on the side that is of the die and that faces the second circuit board, a projection of the first ground terminal in the thickness direction of the second circuit board is located inside the projection of the second connection part in the thickness direction of the second circuit board, and the die is electrically connected to the second connection part via the first ground terminal. In this way, the first ground terminal can be used for thermal conduction between the die and the first thermal conduction sheet, and can be further configured to ground the die, so that utilization of the terminal disposed on the die is high.

In a possible implementation, a surface of one side that is of the second circuit board and that is configured to mount the die has the first thermal conduction sheet. In this way, the thermal conduction pillar and the die can be conveniently connected to the first thermal conduction sheet located on the surface of the second circuit board. In addition, a thermal conduction path of the thermal conduction pillar, the die, and the first thermal conduction sheet located on the surface of the second circuit board is also short, so that the die has high heat dissipation efficiency in performing heat dissipation via the thermal conduction pillar.

In a possible implementation, the die includes a first part and a second part, the first part includes a first core, the second part includes a second core, and power of the first core is higher than power of the second core. The projection of the second connection part in the thickness direction of the second circuit board is located inside a projection of the first part in the thickness direction of the second circuit board, and the projection of the second connection part in the thickness direction of the second circuit board is located outside a projection of the second part in the thickness direction of the second circuit board. In this way, the first core with higher power is disposed close to the second connection part, and a thermal conduction path between the first core and the first thermal conduction sheet is short, so that a large amount of heat generated when the first core runs is efficiently dissipated via the first thermal conduction sheet and the thermal conduction pillar, and the die and the package assembly have low overheating risk.

The first core is configured to: run when the package assembly needs to run with high power consumption, and stop running when the package assembly does not need to run with high power consumption. When the package assembly does not need to run with high power consumption, the second core may run to meet a requirement of the package assembly. For example, the first core may be a performance core of a central processing unit (central processing unit, CPU) or a graphics processing unit (graphics processing unit, GPU), and the performance core may also be referred to as a big core. The second core may be an efficient core of a central processing unit or a graphics processing unit, and the efficient core may also be referred to as a little core.

In a possible implementation, the die has the first connection part, and the thermal conduction pillar is connected to the die, to implement thermal conduction between the thermal conduction pillar and the die. In this way, heat generated by the die can be directly transferred to the heat dissipation apparatus via the thermal conduction pillar for heat dissipation, so that a thermal conduction path between the die and the heat dissipation apparatus is short, and heat dissipation efficiency of the die is high.

In a possible implementation, the die includes a first part and a second part, the first part includes a first core, the second part includes a second core, power of the first core is higher than power of the second core, and the first part has the first connection part. In this way, the first core with higher power is disposed close to the first connection part, and a thermal conduction path between the first core and the thermal conduction pillar is short, so that a large amount of heat generated when the first core runs is efficiently dissipated via the thermal conduction pillar, and the die and the package assembly have low overheating risk.

In a possible implementation, the first chip includes a second circuit board, a die, and a third circuit board. The die is disposed on one side of the second circuit board in a thickness direction, the other side of the second circuit board in the thickness direction is configured to be connected to the first circuit board, and the second chip is disposed on one side that is of the die and that is away from the second circuit board. The third circuit board is disposed between the die and the second chip, one side that is of the third circuit board and that faces the second chip is connected to the second chip, and one side that is of the third circuit board and that is away from the second chip is connected to the second circuit board. A second thermal conduction structure is disposed between the die and the third circuit board, and the die is connected to the third circuit board via the second thermal conduction structure, to implement thermal conduction between the die and the third circuit board via the second thermal conduction structure. The third circuit board has the first connection part, and the thermal conduction pillar is connected to the third circuit board, to implement thermal conduction between the thermal conduction pillar and the third circuit board. In this way, the first chip is connected to the second chip via the third circuit board, so that a spacing at a joint between the first chip and the second chip can be small, thereby facilitating connection between the first chip and the second chip. On the basis that the first chip and the second chip are conveniently connected, heat generated by the die can be transferred to the heat dissipation apparatus via the second thermal conduction structure, the third circuit board, and the thermal conduction pillar for heat dissipation, so that heat dissipation efficiency of the die is high.

In a possible implementation, the second thermal conduction structure includes a first pad and a second pad disposed opposite to the first pad. The first pad is disposed on a surface of the side that is of the die and that is away from the second circuit board, the second pad is disposed on a surface of the side that is of the third circuit board and that is away from the second chip, the first pad is soldered to the corresponding second pad via a solder disposed between the first pad and the second pad, and thermal conduction between the die and the third circuit board is implemented via the first pad and the second pad that are soldered. In this way, thermal connection between the die and the third circuit board is stable. In addition, the thermal connection between the die and the third circuit board is also conveniently implemented.

In a possible implementation, the third circuit board has a second thermal conduction sheet, and the first connection part and the second thermal conduction structure are both connected to the second thermal conduction sheet, to implement thermal conduction between the first connection part and the second thermal conduction structure via the second thermal conduction sheet. In this way, heat generated by the die can be transferred to the thermal conduction pillar via the second thermal conduction structure, the second thermal conduction sheet, and the first connection part, so that when thermal conduction between the die and the thermal conduction pillar is implemented via the second thermal conduction structure and the third circuit board, thermal conduction efficiency between the die and the thermal conduction pillar is high. In addition, arrangement positions of the first connection part and the second thermal conduction structure can be flexible.

In a possible implementation, at least a part of the projection of the first connection part in the thickness direction of the first chip is located inside a projection of the second thermal conduction sheet in the thickness direction of the first chip. In this way, the first connection part can be conveniently connected to the second thermal conduction sheet. In addition, a thermal conduction path between the first connection part and the second thermal conduction sheet is short, so that thermal conduction efficiency is high.

In a possible implementation, at least a part of a projection of the die in the thickness direction of the first chip is located inside the projection of the second thermal conduction sheet in the thickness direction of the first chip. In this way, the die can be conveniently connected to the second thermal conduction sheet via the second thermal conduction structure. In addition, a thermal conduction path between the die and the second thermal conduction sheet can be short, so that thermal conduction efficiency is high.

In a possible implementation, the first connection part is disposed on a surface of one side that is of the third circuit board and that faces the second chip. In this way, the thermal conduction pillar can be conveniently connected to the first connection part.

In a possible implementation, the second thermal conduction sheet is located at an inner layer of the third circuit board. The first connection part is connected to the second thermal conduction sheet via a first thermal conduction body embedded in the third circuit board, to implement thermal conduction between the first connection part and the second thermal conduction sheet via the first thermal conduction body. The second thermal conduction structure is connected to the second thermal conduction sheet via a second thermal conduction body embedded in the third circuit board, to implement thermal conduction between the second thermal conduction structure and the second thermal conduction sheet via the second thermal conduction body. In this way, the second thermal conduction sheet has small impact on arrangement of structures such as a terminal and a pad on a surface of the third circuit board, so that impact on connection between the third circuit board and the second circuit board and connection between the third circuit board and the second chip is small.

In a possible implementation, a third thermal conduction structure is disposed on the surface of the side that is of the third circuit board and that faces the second chip, and a projection of the third thermal conduction structure in the thickness direction of the first chip is located inside the projection of the second chip in the thickness direction of the first chip. In this way, the third thermal conduction structure fills a part of a gap between the third circuit board and the second chip. This helps improve thermal conduction efficiency between the third circuit board and the second chip, and further improves efficiency of performing heat dissipation on the third circuit board via the second chip.

In a possible implementation, the third thermal conduction structure includes a third pad disposed on a surface of the third circuit board and a solder ball disposed on a surface of the third pad. Thermal conduction between the third circuit board and the solder ball disposed on the surface of the third pad is implemented via the third pad. In this way, the third pad and the solder ball disposed on the third pad occupy a small board area, so that the third thermal conduction structure is disposed in a narrow space between the second chip and the third circuit board.

In a possible implementation, the first chip includes a package structure, at least a part of the die of the first chip is covered by the package structure, and the package structure may protect the die.

In a possible implementation, the thermal conduction pillar is disposed outside the package structure. In this way, the package structure does not easily affect thermal conduction of the thermal conduction pillar, so that efficiency for the die to transfer heat to the heat dissipation apparatus via the thermal conduction pillar is high.

In a possible implementation, a side surface of one end that is of the thermal conduction pillar and that is connected to the first connection part is covered by the package structure. In this way, the thermal conduction pillar and the first chip can be stably connected.

In a possible implementation, the first chip is a logic chip or a system-on-chip, and the second chip is a storage chip. In this way, signal transmission paths between the logic chip or the system-on-chip and the storage chip and between the logic chip or the system-on-chip and the first circuit board are short, and signals exchanged between the logic chip or the system-on-chip and the storage chip and between the logic chip or the system-on-chip and the first circuit board have a small loss and a high transmission rate, so that the electronic device can have good processing performance.

A second aspect of this application provides an electronic device, including a first circuit board, a heat dissipation apparatus, and the package assembly in any one of the foregoing implementations. The package assembly is disposed between the first circuit board and the heat dissipation apparatus. One side that is of a first chip of the package assembly and that is away from a second chip of the package assembly is connected to the first circuit board, and the second chip and an end that is of a thermal conduction pillar of the package assembly and that is away from the first chip are both connected to the heat dissipation apparatus, to implement thermal conduction between the heat dissipation apparatus and both the thermal conduction pillar and the second chip.

In a possible implementation of the electronic device provided in the second aspect, the electronic device further includes a shielding cover. The shielding cover is mounted on the first circuit board, and the heat dissipation apparatus is disposed on one side that is of the shielding cover and that is away from the first circuit board. A mounting space is formed between the shielding cover and the first circuit board, and the first chip and the second chip are both disposed in the mounting space. The shielding cover can perform electromagnetic shielding on the first chip and the second chip, and therefore can reduce electromagnetic interference caused by a component outside the shielding cover to the first chip and the second chip.

In a possible implementation of the electronic device provided in the second aspect, the shielding cover is connected to the heat dissipation apparatus, to implement thermal conduction between the shielding cover and the third circuit board the heat dissipation apparatus. The thermal conduction pillar is disposed in the mounting space, and the end that is of the thermal conduction pillar and that is away from the first chip is connected to the shielding cover, so that the thermal conduction pillar is connected to the heat dissipation apparatus via the shielding cover, to implement thermal conduction between the thermal conduction pillar and the heat dissipation apparatus via the shielding cover. In this way, the shielding cover has good shielding effect on a component in the mounting space. In addition, the thermal conduction pillar is assembled easily.

In a possible implementation of the electronic device provided in the second aspect, the shielding cover has a through hole communicating the mounting space with the outside of the shielding cover, and the thermal conduction pillar passes through the through hole. In this way, thermal conduction efficiency between the thermal conduction pillar and the heat dissipation apparatus is high, so that heat dissipation efficiency of the first chip is high.

A third aspect of this application provides an electronic device, including a first circuit board, a heat dissipation apparatus, a package assembly, and a thermal conduction pillar. The package assembly and the thermal conduction pillar are both disposed between the first circuit board and the heat dissipation apparatus. The package assembly includes a first chip and a second chip, the second chip is disposed on one side of the first chip in a thickness direction, the other side of the first chip in the thickness direction is connected to the first circuit board, and one side that is of the second chip and that is away from the first chip is connected to the heat dissipation apparatus, to implement thermal conduction between the second chip and the heat dissipation apparatus. The first circuit board has a third thermal conduction sheet, the third thermal conduction sheet has a third connection part and a fourth connection part, a projection of the third connection part in a thickness direction of the first circuit board is located outside a projection of the package assembly in the thickness direction of the first circuit board, and a projection of the fourth connection part in the thickness direction of the first circuit board is located inside a projection of the first chip in the thickness direction of the first circuit board. One end of the thermal conduction pillar is connected to the third connection part, to implement thermal conduction between the thermal conduction pillar and the third thermal conduction sheet; the other end of the thermal conduction pillar is connected to the heat dissipation apparatus, to implement thermal conduction between the thermal conduction pillar and the heat dissipation apparatus; and the fourth connection part is connected to the first chip, to implement thermal conduction between the third thermal conduction sheet and the first chip.

In this way, the third thermal conduction sheet, the thermal conduction pillar, and the heat dissipation apparatus between which thermal conduction is implemented form a heat dissipation path of the first chip, and heat generated by the first chip can be transferred to the heat dissipation apparatus via the third thermal conduction sheet and the thermal conduction pillar for heat dissipation. Compared with a heat dissipation path in which a first chip transfers heat to a heat dissipation apparatus via a second chip, the heat dissipation path formed by the third thermal conduction sheet and the thermal conduction pillar has lower thermal resistance. Compared with the first circuit board, the heat dissipation apparatus has higher heat dissipation efficiency, and therefore the first chip has higher heat dissipation efficiency. This helps improve heat dissipation efficiency of the package assembly, and can further reduce a limitation on performance of the package assembly caused by low heat dissipation efficiency. In addition, the thermal conduction pillar is connected to the first circuit board, so that the thermal conduction pillar is easily connected. In addition, the thermal conduction pillar may be disposed without affecting packaging of the package assembly.

The third thermal conduction sheet may be a metal sheet formed by a metal layer of the first circuit board. For example, the third thermal conduction sheet may be a copper sheet.

In a possible implementation of the electronic device provided in the third aspect, one side that is of the first chip and that faces the first circuit board includes a second electrical connection region, and a projection of the second electrical connection region in the thickness direction of the first circuit board is located outside a projection of the third thermal conduction sheet in the thickness direction of the first circuit board. A second power terminal and a second signal terminal are disposed on the side that is of the first chip and that faces the first circuit board, the second power terminal and the second signal terminal are both located in the second electrical connection region, and the first chip is electrically connected to the first circuit board via the second power terminal and the second signal terminal. A fourth thermal conduction structure is disposed between the first chip and the fourth connection part, and the first chip is connected to the fourth connection part via the fourth thermal conduction structure, to implement thermal conduction between the first chip and the third thermal conduction sheet via the fourth thermal conduction structure. In this way, the first chip is electrically connected to the first circuit board having the third thermal conduction sheet, and the third thermal conduction sheet has small impact on current and signal transmission between the first circuit board and the first chip. In addition, the second power terminal and the second signal terminal are both disposed outside an overlapping region between the first chip and the third thermal conduction sheet. This facilitates arrangement of a finished third thermal conduction sheet with a large size and good integrity, so that thermal conduction efficiency of the third thermal conduction sheet is high.

The second power terminal is a terminal for power supply between the first chip and the second circuit board, and the second signal terminal is a terminal for signal transmission between the first chip and the second circuit board.

In a possible implementation of the electronic device provided in the third aspect, the third thermal conduction sheet is made of a conductive material, the fourth thermal conduction structure includes a second ground terminal disposed on the side that is of the first chip and that faces the first circuit board, a projection of the second ground terminal in the thickness direction of the first circuit board is located inside the projection of the fourth connection part in the thickness direction of the first circuit board, and the first chip is electrically connected to the fourth connection part via the second ground terminal. In this way, the second ground terminal can be used for thermal conduction between the first chip and the third thermal conduction sheet, and can be further used for grounding of the first chip, so that utilization of the terminal disposed on the first chip is high.

In a possible implementation, a surface of one side that is of the first circuit board and that is configured to mount the first chip has the third thermal conduction sheet. In this way, the thermal conduction pillar and the first chip can be conveniently connected to the third thermal conduction sheet located on the surface of the first circuit board. In addition, a thermal conduction path of the thermal conduction pillar, the first chip, and the third thermal conduction sheet located on the surface of the first circuit board is also short, so that the first chip has high heat dissipation efficiency in performing heat dissipation via the thermal conduction pillar.

In a possible implementation, the first chip includes a third part and a fourth part, the third part includes a first core, the fourth part includes a second core, and power of the first core is higher than power of the second core. The projection of the fourth connection part in the thickness direction of the first circuit board is located inside a projection of the third part in the thickness direction of the first circuit board, and the projection of the fourth connection part in the thickness direction of the first circuit board is located outside a projection of the fourth part in the thickness direction of the first circuit board. In this way, the first core with higher power is disposed close to the fourth connection part, and a thermal conduction path between the first core and the third thermal conduction sheet is short, so that a large amount of heat generated when the first core runs is efficiently dissipated via the third thermal conduction sheet and the thermal conduction pillar, and the first chip and the package assembly have low overheating risk.

In a possible implementation of the electronic device provided in the third aspect, the electronic device further includes a shielding cover. The shielding cover is mounted on the first circuit board, and the heat dissipation apparatus is disposed on one side that is of the shielding cover and that is away from the first circuit board. A mounting space is formed between the shielding cover and the first circuit board, and the first chip and the second chip are both disposed in the mounting space. The thermal conduction pillar is disposed outside the shielding cover. In this way, the disposed shielding cover can perform electromagnetic shielding on the first chip and the second chip, and therefore can reduce electromagnetic interference caused by a component outside the shielding cover to the first chip and the second chip. In addition, the thermal conduction pillar does not affect disposing of the shielding cover, and the thermal conduction pillar and the shielding cover are both conveniently mounted.

In a possible implementation of the electronic device provided in the third aspect, the first chip is a logic chip or a system-on-chip, and the second chip is a storage chip. In this way, signal transmission paths between the logic chip or the system-on-chip and the storage chip and between the logic chip or the system-on-chip and the first circuit board are short, and signals exchanged between the logic chip or the system-on-chip and the storage chip and between the logic chip or the system-on-chip and the first circuit board have a small loss and a high transmission rate, so that the electronic device can have good processing performance.

### BRIEF DESCRIPTION OF DRAWINGS

FIG. 1 is a diagram of an electronic device according to an embodiment of this application;
FIG. 2 is a diagram of another electronic device according to an embodiment of this application;
FIG. 3 is a diagram of arrangement of thermal conduction pillars and a second chip on a first chip of an electronic device according to an embodiment of this application;
FIG. 4 is a diagram of another electronic device according to an embodiment of this application;
FIG. 5 is a diagram of another electronic device according to an embodiment of this application;
FIG. 6 is a diagram of cooperation between a first die and a first thermal conduction sheet of an electronic device according to an embodiment of this application;
FIG. 7 is a diagram of cooperation between a first die and a first thermal conduction sheet of another electronic device according to an embodiment of this application;
FIG. 8 is a diagram of cooperation between a first die and a first thermal conduction sheet of another electronic device according to an embodiment of this application;
FIG. 9 is a diagram of cooperation between a first die and a first thermal conduction sheet of another electronic device according to an embodiment of this application;
FIG. 10 is a diagram of another electronic device according to an embodiment of this application;
FIG. 11 is a diagram of another electronic device according to an embodiment of this application;
FIG. 12 is a diagram of another electronic device according to an embodiment of this application;
FIG. 13 is a diagram of another electronic device according to an embodiment of this application;
FIG. 14 is a process flowchart of a preparation method for an electronic device according to an embodiment of this application;
FIG. 15 is a diagram of another electronic device according to an embodiment of this application;
FIG. 16 is a diagram of another electronic device according to an embodiment of this application;
FIG. 17 is a diagram of another electronic device according to an embodiment of this application;
FIG. 18 is a diagram of another electronic device according to an embodiment of this application;
FIG. 19 is a diagram of another electronic device according to an embodiment of this application;
FIG. 20 is a diagram of another electronic device according to an embodiment of this application;
FIG. 21 is a diagram of another electronic device according to an embodiment of this application;
FIG. 22 is a diagram of cooperation between a first chip and a third thermal conduction sheet of an electronic device according to an embodiment of this application;
FIG. 23 is a diagram of cooperation between a first chip and a third thermal conduction sheet of another electronic device according to an embodiment of this application;
FIG. 24 is a diagram of cooperation between a first chip and a third thermal conduction sheet of another electronic device according to an embodiment of this application;
FIG. 25 is a diagram of cooperation between a first chip and a third thermal conduction sheet of another electronic device according to an embodiment of this application;
FIG. 26 is a diagram of another electronic device according to an embodiment of this application;
FIG. 27 is a diagram of a thermal conduction pillar according to an embodiment of this application;
FIG. 28 is a diagram of another thermal conduction pillar according to an embodiment of this application; and
FIG. 29 is a diagram of another thermal conduction pillar according to an embodiment of this application.

### Description of reference numerals:

10: package assembly; 20: heat dissipation apparatus; 30: thermal conduction pillar; 31: first segment; 32: second segment; 33: third segment; 34: fourth segment; 35: fifth segment; 36: sixth segment; 40: shielding cover; 41: through hole; 50: thermal interface material;
100: first circuit board; 110: third thermal conduction sheet; 111: third connection part; 112: fourth connection part;
200: first chip; 210: second circuit board; 211: first thermal conduction sheet; 2111: second connection part; 212: second electrical connection region; 213: second thermal conduction region; 220: first die; 221: first part; 222: second part; 223: first electrical connection region; 224: first core; 225: second core; 226: first thermal conduction region; 227: second thermal conduction structure; 2271: first pad; 2272: first solder; 2273: second pad; 230: first package structure; 240: third part; 250: fourth part; 260: conductive pillar; 270: first connection part; 271: second solder; 280: third circuit board; 281: second thermal conduction sheet; 282: third thermal conduction structure; 2821: third pad; 2822: solder ball; 283: first thermal conduction body; 284: second thermal conduction body; 285: fifth electrical connection terminal; 290: second filling medium;
300: second chip; 310: fourth circuit board; 320: second die; 330: second package structure;
400: first filling medium;
510: first electrical connection terminal; 511: first power terminal; 512: first signal terminal; 520: second electrical connection terminal; 521: second power terminal; 522: second signal terminal; 530: first thermal conduction structure; 531: first ground terminal; 540: fourth thermal conduction structure; 541: second ground terminal; 550: third electrical connection terminal; 560: first connection terminal; and 570: second connection terminal.

### DESCRIPTION OF EMBODIMENTS

Terms used in implementations of this application are merely intended to describe specific embodiments of this application, but not to limit this application. The following describes implementations of embodiments of this application in detail with reference to the accompanying drawings.

Embodiments of this application provide an electronic device. The electronic device may include but is not limited to a mobile phone, a tablet computer (portable Android device, PAD), a notebook computer, a personal digital assistant (personal digital assistant, PDA), a server, a switch, a computing device, a vehicle-mounted device, a wearable device, a virtual reality (virtual reality, VR) terminal device, an augmented reality (augmented reality, AR) terminal device, a wireless terminal in industrial control (industrial control), a wireless terminal in self driving (self driving), a wireless terminal in telemedicine (remote medical), a wireless terminal in a smart grid (smart grid), a wireless terminal in transportation safety (transportation safety), a wireless terminal in a smart city (smart city), a wireless terminal in a smart home (smart home), and the like.

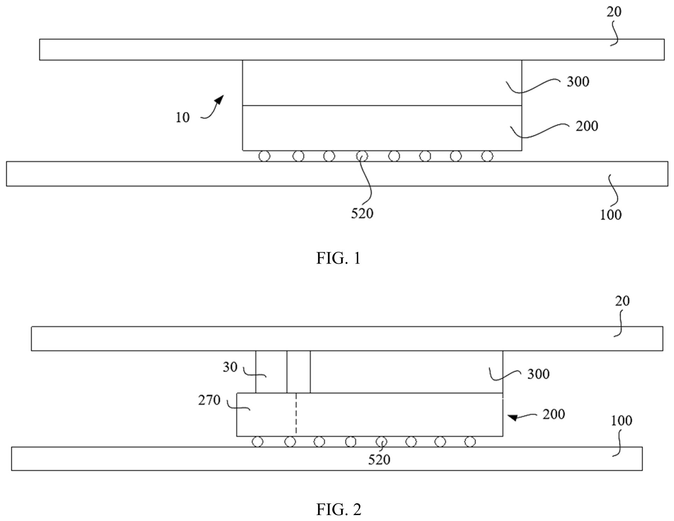

FIG. 1 is a diagram of an electronic device according to an embodiment of this application.

As shown in FIG. 1, in this embodiment of this application, the electronic device may include a first circuit board 100, a package assembly 10, and a heat dissipation apparatus 20. The package assembly 10 is mounted on a surface of the first circuit board 100, and the heat dissipation apparatus 20 is disposed on one side that is of the package assembly 10 and that is away from the first circuit board 100. In other words, the package assembly 10 is disposed between the first circuit board 100 and the heat dissipation apparatus 20. The side that is of the package assembly 10 and that is away from the first circuit board 100 is connected to the heat dissipation apparatus 20, so that thermal conduction between the package assembly 10 and the heat dissipation apparatus 20 is implemented, and the package assembly 10 can dissipate heat via the heat dissipation apparatus 20.

For example, the heat dissipation apparatus 20 may include but is not limited to a liquid-cooled plate, a vapor chamber, or a graphite sheet.

For example, the first circuit board 100 may include but is not limited to a main board or a service board of the electronic device.

In this embodiment of this application, the package assembly 10 includes a first chip 200 and a second chip 300. To enable the package assembly 10 to occupy a small board area on the first circuit board 100, the first chip 200 and the second chip 300 are stacked. The package assembly 10 may be a package assembly formed through package on package. For example, the package assembly 10 may be a package assembly formed through high band package on package (High band package on package, HBPOP).

Specifically, the second chip 300 is disposed on one side of the first chip 200 in a thickness direction, and the other side of the first chip 200 in the thickness direction is connected to the first circuit board 100. The heat dissipation apparatus 20 is disposed on one side that is of the second chip 300 and that is away from the first chip 200, and the side that is of the second chip 300 and that is away from the first chip 200 is connected to the heat dissipation apparatus 20, so that thermal conduction between the second chip 300 and the heat dissipation apparatus 20 is implemented, and the second chip 300 can dissipate heat via the heat dissipation apparatus 20.

For example, a second electrical connection terminal 520 may be disposed on the side that is of the first chip 200 and that is away from the second chip 300, and the first chip 200 may be fastened to and electrically connected to the first circuit board 100 via the second electrical connection terminal 520.

The second electrical connection terminal 520 may include but is not limited to a solder ball structure, a solder pillar structure, a pin structure, or a conductive bump. A plurality of arrayed second electrical connection terminals 520 may be disposed on the side that is of the first chip 200 and that is away from the second chip 300.

In a related technology, a heat dissipation path of the first chip close to the first circuit board is to transfer generated heat to the heat dissipation apparatus via the second chip for heat dissipation. However, the second chip usually has large thermal resistance, resulting in large thermal resistance between the first chip and the heat dissipation apparatus. Consequently, efficiency of transferring the heat of the first chip to the heat dissipation apparatus via the second chip is low, and therefore efficiency of dissipating the heat of the first chip via the second chip is low. Another heat dissipation path of the first chip close to the first circuit board is to transfer generated heat to the first circuit board via a structure, like the second electrical connection terminal, configured to be connected to the first circuit board for heat dissipation. However, heat on the first circuit board can usually be dissipated only to the air in an environment in which the first circuit board is located. Consequently, heat exchange efficiency between the first circuit board and the air in the environment is low, and therefore efficiency of dissipating the heat of the first chip via the first circuit board is low. In conclusion, in the package assembly in the related technology, the first chip close to the first circuit board has low heat dissipation efficiency, resulting in low heat dissipation efficiency of the entire package assembly and a limitation on performance of the package assembly due to the low heat dissipation efficiency of the package assembly.

Based on this, in embodiments of this application, a thermal conduction pillar 30 (as shown in FIG. 2 below) is disposed, where thermal conduction between one end of the thermal conduction pillar 30 and the heat dissipation apparatus 20 and thermal conduction between the other end of the thermal conduction pillar 30 and the first chip 200 are implemented. Heat generated by the first chip 200 can be transferred to the heat dissipation apparatus 20 via the thermal conduction pillar 30, so that thermal resistance between the first chip 200 and the heat dissipation apparatus 20 is low, and the first chip 200 can efficiently dissipate heat via the thermal conduction pillar 30 and the heat dissipation apparatus 20. This helps improve heat dissipation efficiency of the package assembly 10, and can further reduce a limitation on performance of the package assembly 10 caused by low heat dissipation efficiency.

In some examples, after the thermal conduction pillar 30 is disposed, thermal conduction between the first chip 200 and the first circuit board 100 may also be implemented via a connection structure like the second electrical connection terminal 520, so that a part of heat on the first chip 200 can also be dissipated via the first circuit board 100 to an environment in which the first circuit board 100 is located.

In some examples, after the thermal conduction pillar 30 is disposed, thermal conduction between the first chip 200 and the second chip 300 may also be implemented, so that a part of heat on the first chip 200 can also be transferred to the heat dissipation apparatus 20 via the second chip 300 for heat dissipation.

In other words, in some examples, after the thermal conduction pillar 30 is disposed, the first chip 200 may have a heat dissipation path for transferring the heat to the heat dissipation apparatus 20 via the thermal conduction pillar 30 for heat dissipation, a heat dissipation path for transferring the heat to the heat dissipation apparatus 20 via the second chip 300 for heat dissipation, and a heat dissipation path for transferring, via the connection structure like the second electrical connection terminal 520 connected to the first circuit board 100, the heat to the first circuit board 100 to dissipate the heat to the environment in which the first circuit board 100 is located.

For example, a material for forming the thermal conduction pillar 30 may include one or more of the following: copper, silver, aluminum, and silicon.

For example, the thermal conduction pillar 30 may be of a structure like a cylinder or a square column. A length and a width of the thermal conduction pillar 30 may be unequal.

FIG. 2 is a diagram of another electronic device according to an embodiment of this application.

As shown in FIG. 2, in some possible implementations, the package assembly 10 may include a thermal conduction pillar 30, and a projection of the thermal conduction pillar 30 in a thickness direction of the first chip 200 is located outside a projection of a second chip 300 in the thickness direction of the first chip 200. The first chip 200 has a first connection part 270, and a projection of the first connection part 270 in the thickness direction of the first chip 200 is located outside the projection of the second chip 300 in the thickness direction of the first chip 200. An end of the thermal conduction pillar 30 is connected to the first connection part 270, to implement thermal conduction between the thermal conduction pillar 30 and the first chip 200. In other words, the end of the thermal conduction pillar 30 is connected to a part that is of the first chip 200 and that does not overlap the second chip 300. The other end of the thermal conduction pillar 30 protrudes from a surface of one side that is of the first chip 200 and that faces the second chip 300, and is connected to a heat dissipation apparatus 20, so that the thermal conduction pillar 30 is configured for thermal conduction with the heat dissipation apparatus 20, and thermal conduction between the first chip 200 and the heat dissipation apparatus 20 can be implemented via the thermal conduction pillar 30.

In this way, the thermal conduction pillar 30 is connected to the heat dissipation apparatus 20 to form a heat dissipation path of the first chip 200, so that heat generated by the first chip 200 can be transferred to the heat dissipation apparatus 20 via the thermal conduction pillar 30 for heat dissipation. Compared with that in a heat dissipation path in which the first chip 200 transfers the heat to the heat dissipation apparatus 20 via the second chip 300, the thermal conduction pillar 30 has lower thermal resistance. Compared with a first circuit board 100, the heat dissipation apparatus 20 has higher heat dissipation efficiency, and therefore the first chip 200 has higher heat dissipation efficiency. This helps improve heat dissipation efficiency of the package assembly 10, and can further reduce a limitation on performance of the package assembly 10 caused by low heat dissipation efficiency.

For example, the thermal conduction pillar 30 may be disposed on one or more sides of the second chip 300.

For example, the thermal conduction pillars 30 may be disposed on any two sides of the second chip 300.

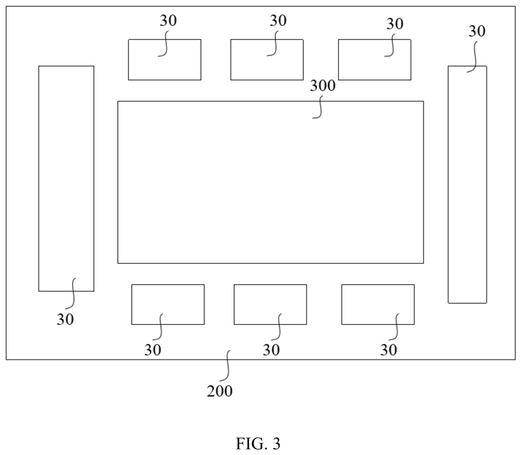

FIG. 3 is a diagram of arrangement of thermal conduction pillars and a second chip on a first chip of an electronic device according to an embodiment of this application. Refer to FIG. 3. For another example, thermal conduction pillars 30 may be disposed around a second chip 300.

Positions, lengths and widths, and a quantity of the thermal conduction pillars 30 disposed on a first chip 200 may be determined based on a layout of the first chip 200 and the second chip 300.

For example, the first chip 200 may include but is not limited to a system-on-chip (system-on-chip, SOC), a logic chip, a storage chip, a sensing chip, a communication chip, or an energy chip.

For example, the second chip 300 may include but is not limited to a system-on-chip, a logic chip, a storage chip, a sensing chip, a communication chip, or an energy chip.

In some possible implementations, the first chip 200 is a logic chip or a system-on-chip, and the second chip 300 is a storage chip.

In this way, the logic chip or the system-on-chip is disposed between a first circuit board 100 and the storage chip, signal transmission paths between the logic chip or the system-on-chip and the storage chip and between the logic chip or the system-on-chip and the first circuit board 100 are short, and signals exchanged between the logic chip or the system-on-chip and the storage chip and between the logic chip or the system-on-chip and the first circuit board 100 have a small loss and a high transmission rate, so that the electronic device can have good processing performance.

For example, the first chip 200 is a system-on-chip, and the second chip 300 is a double data rate synchronous dynamic random access memory (double data rate synchronous dynamic random access memory, DDR SDRAM).

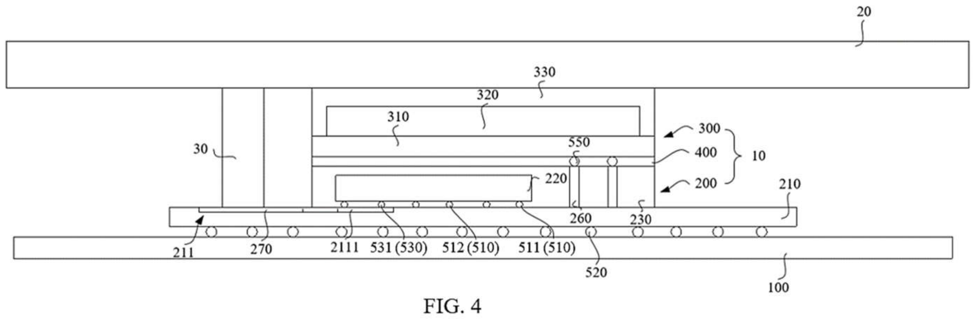

FIG. 4 is a diagram of another electronic device according to an embodiment of this application.

As shown in FIG. 4, in this embodiment of this application, a first chip 200 includes a second circuit board 210 and a first die (die) 220. The first die 220 is disposed on one side of the second circuit board 210 in a thickness direction, the other side of the second circuit board 210 in the thickness direction is configured to be connected to a first circuit board 100, and the second chip 300 is disposed on one side that is of the first die 220 and that is away from the second circuit board 210.

For example, the first die 220 may be a silicon wafer.

For example, the first die 220 may include one or more of the following modules: a central processing unit (central processing unit, CPU), a graphics processing unit (graphics processing unit, GPU), an embedded neural-network processing unit (neural processor unit, NPU), a cache (cache), or an internet service provider (internet service provider, ISP) module.

When the first chip 200 is fastened to and electrically connected to the first circuit board 100 via a second electrical connection terminal 520, the second electrical connection terminal 520 is disposed on one side that is of the second circuit board 210 and that is away from the first die 220, and the second electrical connection terminal 520 enables the side that is of the second circuit board 210 and that is away from the first die 220 to be fastened to and electrically connected to the first circuit board 100.

For example, the first die 220 mounted on the second circuit board 210 may be electrically connected to the second circuit board 210 via a wire.

For example, a first electrical connection terminal 510 may be disposed on one side that is of the first die 220 and that is away from the second chip 300, and the first die 220 may be fastened to and electrically connected to the second circuit board 210 via the first electrical connection terminal 510.

The first electrical connection terminal 510 may include but is not limited to a solder ball structure, a solder pillar structure, a pin structure, or a conductive bump structure. A plurality of arrayed first electrical connection terminals 510 may be disposed on the side that is of the first die 220 and that is away from the second chip 300.

In this embodiment of this application, the first chip 200 further includes a first package structure 230, and at least a part of the first die 220 is covered by the first package structure 230, so that the first package structure 230 can protect the first die 220. The second chip 300 is disposed on one side that is of the first package structure 230 and that is away from the second circuit board 210, and the second chip 300 is connected to the side that is of the first package structure 230 and that is away from the second circuit board 210, so that the first die 220 is connected to the second chip 300 via the first package structure 230.

The first package structure 230 is made of a non-conductive material. For example, a material for forming the first package structure 230 may include one or more of the following: epoxy resin, resin, and moldable polymer.

For example, a third electrical connection terminal 550 may be disposed on one side that is of the second chip 300 and that faces the first chip 200, and the second chip 300 may be fastened to and electrically connected to the first chip 200 via the third electrical connection terminal 550.

The third electrical connection terminal 550 may include but is not limited to a solder ball structure, a solder pillar structure, a pin structure, or a conductive bump structure. A plurality of arrayed third electrical connection terminals 550 may be disposed on the side that is of the second chip 300 and that faces the first chip 200.

For example, a conductive pillar 260 may pass through the first package structure 230. A projection of the conductive pillar 260 in the thickness direction of the first chip 200 is located outside a projection of the first die 220 in the thickness direction of the first chip 200. The conductive pillar 260 penetrates two ends of the first package structure 230 in the thickness direction of the first chip 200. One end of the conductive pillar 260 is electrically connected to the second circuit board 210, and the other end of the conductive pillar 260 may be electrically connected to the second chip 300 via the third electrical connection terminal 550.

For example, a first filling medium 400 is filled between the first chip 200 and the second chip 300, the first filling medium 400 is made of a non-conductive material, and the first filling medium 400 is configured to support the second chip 300, so that the second chip 300 can be stably mounted on the first chip 200.

For example, the first filling medium 400 may be formed by a thermal interface material (thermal interface material, TIM) like silicone grease, so that the first chip 200 and the second chip 300 have good thermal conduction performance.

In this embodiment of this application, the second chip 300 includes a fourth circuit board 310, a second die (die) 320, and a second package structure 330. One side of the fourth circuit board 310 is connected to the side that is of the first chip 200 and that is away from the first circuit board 100, the second die 320 is mounted on the other side of the fourth circuit board 310, and at least a part of the second die 320 is covered by the second package structure 330.

For example, the second die 320 is a silicon wafer.

When the second chip 300 is fastened to and electrically connected to the first chip 200 via the third electrical connection terminal 550, the third electrical connection terminal 550 is disposed on the side that is of the fourth circuit board 310 and that faces the first chip 200, and the third electrical connection terminal 550 enables the side that is of the fourth circuit board 310 and that faces the first chip 200 to be fastened to and electrically connected to the first chip 200.

When the first filling medium 400 is filled between the first chip 200 and the second chip 300, the first filling medium 400 is located between the first package structure 230 and the fourth circuit board 310.

For example, the second die 320 mounted on the fourth circuit board 310 may be electrically connected to the fourth circuit board 310 via a wire.

For example, a fourth electrical connection terminal (not shown) may be disposed on one side that is of the second die 320 and that is away from the second chip 300, and the second die 320 may be fastened to and electrically connected to the fourth circuit board 310 via the fourth electrical connection terminal.

The fourth electrical connection terminal may include but is not limited to a solder ball structure, a solder pillar structure, a pin structure, or a conductive bump structure. A plurality of arrayed fourth electrical connection terminals may be disposed on one side that is of the second die 320 and that faces the fourth circuit board 310.

The second package structure 330 is made of a non-conductive material. For example, a material for forming the second package structure 330 may include one or more of the following: epoxy resin, resin, and moldable polymer.

For example, the first package structure 230 and the second package structure 330 may be a split structure.

For example, the first package structure 230, the second package structure 330, and the first filling medium 400 may be an integrated structure.

For example, the first package structure 230, the second package structure 330, and the first filling medium 400 may be formed by using a same material.

For example, the second package structure 330 may be connected to the heat dissipation apparatus 20 via a thermal interface material.

In some possible implementations, the second circuit board 210 has a first thermal conduction sheet 211, and the first thermal conduction sheet 211 has the first connection part 270 and a second connection part 2111. A projection of the first connection part 270 in the thickness direction of the second circuit board 210 is located outside a projection of the first die 220 in the thickness direction of the second circuit board 210. A projection of the second connection part 2111 in the thickness direction of the second circuit board 210 is located inside the projection of the first die 220 in the thickness direction of the second circuit board 210. The thermal conduction pillar 30 is connected to the first thermal conduction sheet 211, to implement thermal conduction between the thermal conduction pillar 30 and the first thermal conduction sheet 211. The second connection part 2111 is connected to the first die 220, to implement thermal conduction between the first thermal conduction sheet 211 and the first die 220, and implement thermal conduction between the first die 220 and the heat dissipation apparatus 20 via the first thermal conduction sheet 211 and the thermal conduction pillar 30.

In this way, heat generated by the first die 220 can be transferred to the heat dissipation apparatus 20 via the first thermal conduction sheet 211 and the thermal conduction pillar 30 for heat dissipation, so that heat dissipation efficiency of the first die 220 is high. In addition, the thermal conduction pillar 30 is connected to the second circuit board 210, so that the thermal conduction pillar 30 is easily connected. In addition, the thermal conduction pillar 30 is disposed without affecting packaging of the first die 220, and this helps dispose, on a surface of the first die 220, the first package structure 230 configured to protect the first die 220.

For example, a material for forming the first thermal conduction sheet 211 may include one or more of the following: copper, silver, and aluminum.

For example, the second circuit board 210 may include at least one metal layer, and the first thermal conduction sheet 211 may be a metal sheet formed by one of metal layers of the second circuit board 210. For example, the first thermal conduction sheet 211 may be a copper sheet.

For example, the first thermal conduction sheet 211 may be a grounded metal sheet in the second circuit board 210.

For example, the first thermal conduction sheet 211 may be insulated from a grounded part in the second circuit board 210.

For example, the thermal conduction pillar 30 may be connected to the first thermal conduction sheet 211 through soldering, bonding by using a thermally conductive adhesive, or the like.

For example, the second connection part 2111 may be connected to the first die 220 through bonding by using a thermally conductive adhesive.

In some possible implementations, a surface of one side that is of the second circuit board 210 and that is configured to mount the first die 220 has the first thermal conduction sheet 211. In other words, the first thermal conduction sheet 211 is formed on a metal layer at a surface layer of the second circuit board 210.

In this way, the thermal conduction pillar 30 and the first die 220 can be conveniently connected to the first thermal conduction sheet 211 located on the surface of the second circuit board 210. In addition, a thermal conduction path of the thermal conduction pillar 30, the first die 220, and the first thermal conduction sheet 211 located on the surface of the second circuit board 210 is also short, so that the first die 220 has high heat dissipation efficiency in performing heat dissipation via the thermal conduction pillar 30.

When the second circuit board 210 includes a plurality of metal layers, the second circuit board 210 may have a plurality of first thermal conduction sheets 211 distributed on different metal layers, and thermal conduction between the plurality of first thermal conduction sheets 211 distributed on the different metal layers may be implemented via a thermal conduction structure passing through a via hole in the second circuit board 210.

In some examples in which the second circuit board 210 includes the first thermal conduction sheet 211, a part of the second circuit board 210 is not covered by the first package structure 230, and the thermal conduction pillar 30 is disposed outside the first package structure 230.

In this way, the first package structure 230 does not easily affect thermal conduction of the thermal conduction pillar 30, so that the first thermal conduction sheet 211 has high efficiency in transferring heat to the heat dissipation apparatus 20 via the thermal conduction pillar 30.

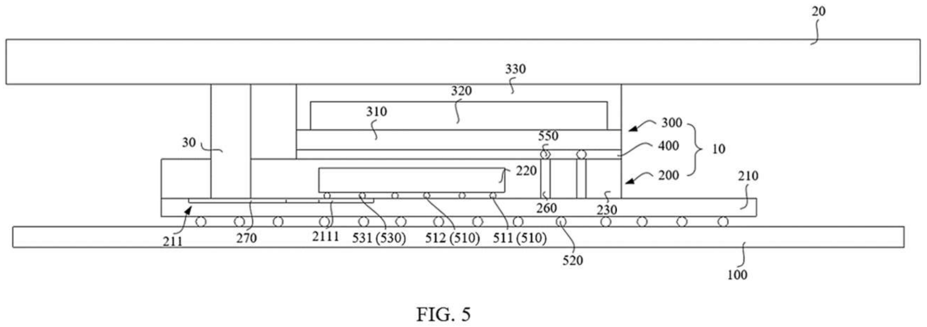

FIG. 5 is a diagram of another electronic device according to an embodiment of this application.

As shown in FIG. 5, in some examples in which the second circuit board 210 includes the first thermal conduction sheet 211, one side surface of an end that is of the thermal conduction pillar 30 and that is connected to the first connection part 270 is covered by the first package structure 230.

In this way, the thermal conduction pillar 30 and the first thermal conduction sheet 211 can be stably connected, and have stable thermal conduction.

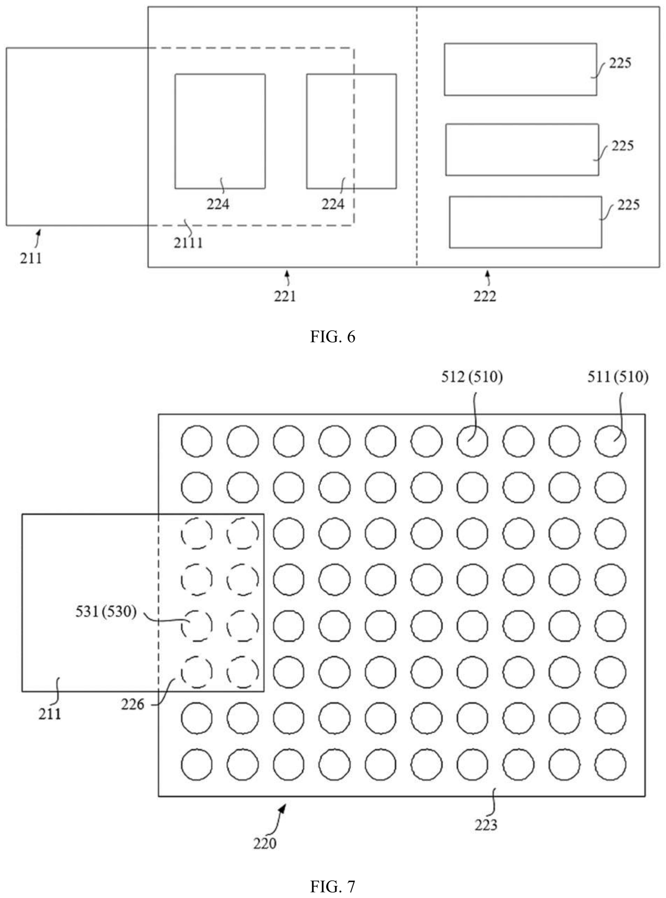

FIG. 6 is a diagram of cooperation between a first die and a first thermal conduction sheet of an electronic device according to an embodiment of this application.

As shown in FIG. 6, with reference to FIG. 5, the first die 220 may include a first part 221 and a second part 222. The first part 221 includes a first core 224, and the second part 222 includes a second core 225. Power of the first core 224 is higher than power of the second core 225. In other words, heat generated when the first core 224 runs is higher than heat generated when the second core 225 runs.

It should be noted that the first core 224 is not necessarily a core with highest power in the first die 220, and the second core is not necessarily a core with lowest power in the first die 220. When the first die 220 includes a plurality of cores, the first core 224 may be any core with higher power in the plurality of cores, and the second core 225 may be any core with lower power in the plurality of cores.

For example, the first core 224 may be configured to run when the package assembly 10 needs to run with high power consumption, and the first core 224 may stop running when the package assembly 10 does not need to run with high power consumption. When the package assembly 10 does not need to run with high power consumption, the second core 225 may run to meet a requirement of the package assembly 10.

For example, the first part 221 may include a plurality of first cores 224.

For example, any first core 224 may include but is not limited to a performance core of a central processing unit or a performance core of a graphics processing unit. The performance core may also be referred to as a big core.

For example, the second part 222 may include a plurality of second cores 225.

For example, any second core 225 may include but is not limited to an embedded neural-network processing unit, a cache, an internet service provider module, an efficient core of a central processing unit, or an efficient core of a graphics processing unit. The efficient core may also be referred to as a little core.

In some examples in which the second circuit board 210 includes the first thermal conduction sheet 211, a projection of the second connection part 2111 in the thickness direction of the second circuit board 210 is located inside a projection of the first part 221 in the thickness direction of the second circuit board 210, and the projection of the second connection part 2111 in the thickness direction of the second circuit board 210 is located outside a projection of the second part 222 in the thickness direction of the second circuit board 210.

In this way, the first core 224 with higher power is disposed close to the second connection part 2111, and a thermal conduction path between the first core 224 and the first thermal conduction sheet 211 is short, so that a large amount of heat generated when the first core 224 runs is efficiently dissipated via the first thermal conduction sheet 211 and the thermal conduction pillar 30, and the first die 220 and the package assembly 10 have low overheating risk.

FIG. 7 is a diagram of cooperation between a first die and a first thermal conduction sheet of another electronic device according to an embodiment of this application.

As shown in FIG. 7, with reference to FIG. 5, in some possible implementations, one side that is of the first die 220 and that faces the second circuit board 210 includes a first electrical connection region 223 and a first thermal conduction region 226. A projection of the first electrical connection region 223 in the thickness direction of the second circuit board 210 is located outside a projection of the first thermal conduction sheet 211 in the thickness direction of the second circuit board 210, and a projection of the first thermal conduction region 226 in the thickness direction of the second circuit board 210 is located inside the projection of the first thermal conduction sheet 211 in the thickness direction of the second circuit board 210.

A plurality of first electrical connection terminals 510 disposed on the side that is of the first die 220 and that faces the second circuit board 210 include a first power terminal 511 and a first signal terminal 512. The first power terminal 511 and the first signal terminal 512 are both located in the first electrical connection region 223. In other words, the first power terminal 511 and the first signal terminal 512 are not disposed in the first thermal conduction region 226. The first die 220 is electrically connected to the second circuit board 210 via the first power terminal 511 and the first signal terminal 512.

A first thermal conduction structure 530 is disposed between the first die 220 and the second connection part 2111. The first die 220 is connected to the second connection part 2111 via the first thermal conduction structure 530. Specifically, the first thermal conduction structure 530 is disposed between the first thermal conduction region 226 and the second connection part 2111, and the first thermal conduction region 226 is connected to the second connection part 2111 via the first thermal conduction structure 530, to implement thermal conduction between the first die 220 and the first thermal conduction sheet 211 via the first thermal conduction structure 530.

In this way, the first die 220 is electrically connected to the second circuit board 210 having the first thermal conduction sheet 211, and the first thermal conduction sheet 211 has small impact on current and signal transmission between the second circuit board 210 and the first die 220. In addition, the first power terminal 511 and the first signal terminal 512 are both disposed outside an overlapping region between the first die 220 and the first thermal conduction sheet 211. This facilitates arrangement of a finished first thermal conduction sheet 211 with a large size and good integrity, so that thermal conduction efficiency of the first thermal conduction sheet 211 is high.

The first power terminal 511 is a terminal for power supply between the first die 220 and the second circuit board 210, and the first signal terminal 512 is a terminal for signal transmission between the first die 220 and the second circuit board 210.

An edge of one side of the first thermal conduction region 226 at least partially overlaps with an edge of one side of the first die 220. In other words, the first electrical connection region 223 is not disposed on at least one side of the first thermal conduction region 226.

For example, a material for forming the first thermal conduction structure 530 may include one or more of the following: copper, silver, and aluminum.

In some examples, the first thermal conduction structure 530 may include a thermal interface material filled between the first thermal conduction region 226 and the second connection part 2111.

In some other examples, the first thermal conduction structure 530 may include a thermal conduction gasket sandwiched between the first thermal conduction region 226 and the second connection part 2111.

In some other examples, the first thermal conduction structure 530 may include a terminal disposed in the first thermal conduction region 226. The terminal disposed in the first thermal conduction region 226 may be disabled, to avoid a short circuit caused by connection between the terminal disposed in the first thermal conduction region 226 and the first thermal conduction sheet 211. In this way, the terminal disposed in the first thermal conduction region 226 can be connected to the first thermal conduction sheet 211, to transfer the heat of the first die 220 to the first thermal conduction sheet 211. In this way, the terminal in the first thermal conduction region 226 can be used to thermally connect the first die 220 to the first thermal conduction sheet 211, so that a connection structure between the first die 220 and the first thermal conduction sheet 211 is simple.

In some possible implementations, the first thermal conduction sheet 211 is made of a conductive material, the first thermal conduction structure 530 includes a first ground terminal 531 disposed on the side that is of the first die 220 and that faces the second circuit board 210, a projection of the first ground terminal 531 in the thickness direction of the second circuit board 210 is located inside the projection of the second connection part 2111 in the thickness direction of the second circuit board 210, and the first die 220 is electrically connected to the second connection part 2111 via the first ground terminal 531.

In this way, the first ground terminal 531 can be used for thermal conduction between the first die 220 and the first thermal conduction sheet 211, and can be further used for grounding of the first die 220, so that utilization of the terminal disposed on the first die 220 is high.

For example, the first thermal conduction structure 530 may be located at an edge of one side that is at least partially overlapped with the first die 220 and the first thermal conduction region 226.

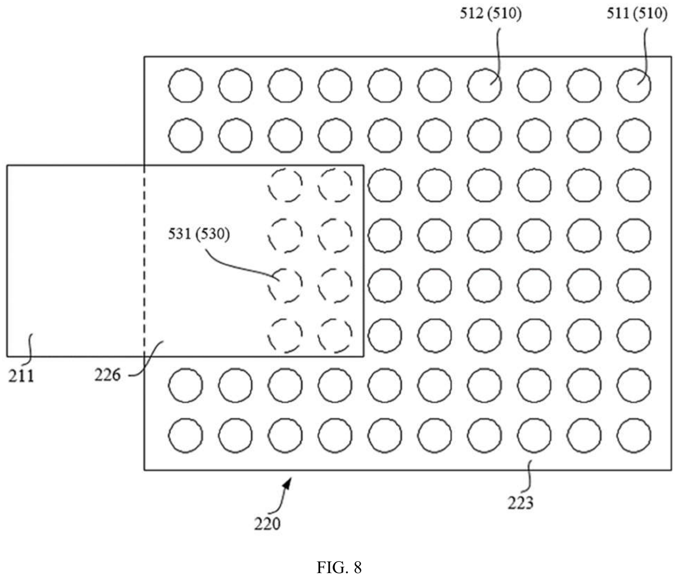

FIG. 8 is a diagram of cooperation between a first die and a first thermal conduction sheet of another electronic device according to an embodiment of this application.

As shown in FIG. 8, in some examples, the first thermal conduction structure 530 may not be located on the edge of the side that is at least partially overlapped with the first die 220 and the first thermal conduction region 226, and all other terminals except the first thermal conduction structure 530 may be cleared in the first thermal conduction region 226.

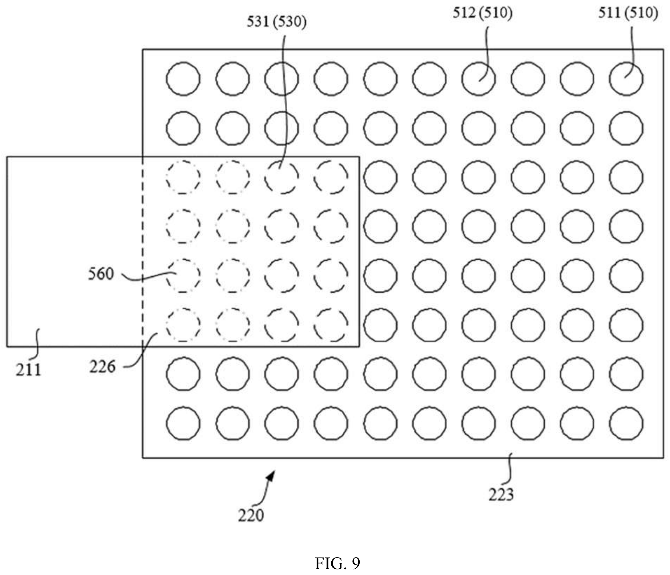

FIG. 9 is a diagram of cooperation between a first die and a first thermal conduction sheet of another electronic device according to an embodiment of this application.

As shown in FIG. 9, in some examples, a first connection terminal 560 whose current interaction function is disabled is further disposed on the side that is of the first die 220 and that faces the second circuit board 210. In other words, there is no current input or output in the first connection terminal 560. The first thermal conduction structure 530 may further include the first connection terminal 560. The first connection terminal 560 may connect the second connection part 2111 to the first thermal conduction region 226, to implement thermal conduction between the first die 220 and the first thermal conduction sheet 211 via the first connection terminal 560. In this way, the first die 220 and the second circuit board 210 can be stably connected.

In some examples, the first connection terminal 560 and the first thermal conduction sheet 211 may be spaced apart, so that the first connection terminal 560 is insulated from the first thermal conduction sheet 211.

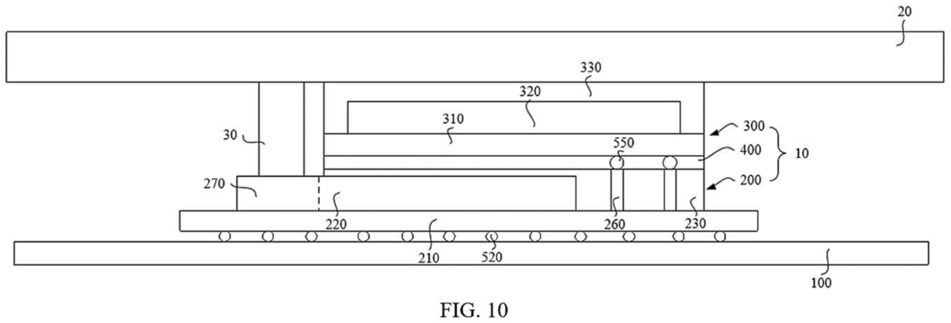

FIG. 10 is a diagram of another electronic device according to an embodiment of this application.

As shown in FIG. 10, in some possible implementations, the first die 220 has the first connection part 270, and the thermal conduction pillar 30 is connected to the first die 220. Specifically, one end of the thermal conduction pillar 30 is connected to the side that is of the first die 220 and that is away from the second circuit board 210, to implement thermal conduction between the thermal conduction pillar 30 and the first die 220.

In this way, heat generated by the first die 220 can be directly transferred to the heat dissipation apparatus 20 via the thermal conduction pillar 30 for heat dissipation, so that a thermal conduction path between the first die 220 and the heat dissipation apparatus 20 is short, and heat dissipation efficiency of the first die 220 is high.

For example, the thermal conduction pillar 30 may be connected to the first die 220 through soldering, bonding by using a thermally conductive adhesive, or the like.

For example, the thermal conduction pillar 30 may be connected to the first die 220 via a thermal interface material.

In some examples in which the first die 220 has the first connection part 270, the first part 221 of the first die 220 has the first connection part 270.

In this way, the first core 224 with higher power is disposed close to the first connection part 270, and a thermal conduction path between the first core 224 and the thermal conduction pillar 30 is short, so that a large amount of heat generated when the first core 224 runs is efficiently dissipated via the thermal conduction pillar 30, and the first die 220 and the package assembly 10 have low overheating risk.

In some examples in which the first die 220 has the first connection part 270, a part of the first die 220 is not covered by the first package structure 230, and the thermal conduction pillar 30 is disposed outside the first package structure 230.

In this way, the first package structure 230 does not easily affect thermal conduction of the thermal conduction pillar 30, so that the first die 220 has high efficiency in transferring heat to the heat dissipation apparatus 20 via the thermal conduction pillar 30.

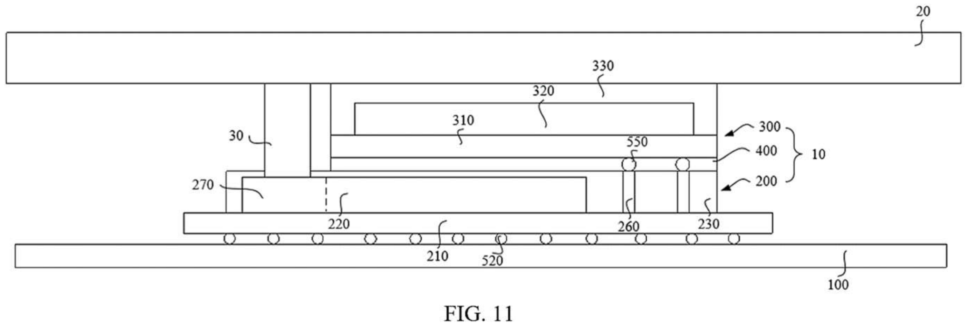

FIG. 11 is a diagram of another electronic device according to an embodiment of this application.

As shown in FIG. 11, in some examples in which the first die 220 has the first connection part 270, the side surface of the end that is of the thermal conduction pillar 30 and that is connected to the first connection part 270 is covered by the first package structure 230.

In this way, the thermal conduction pillar 30 and the first die 220 can be stably connected.

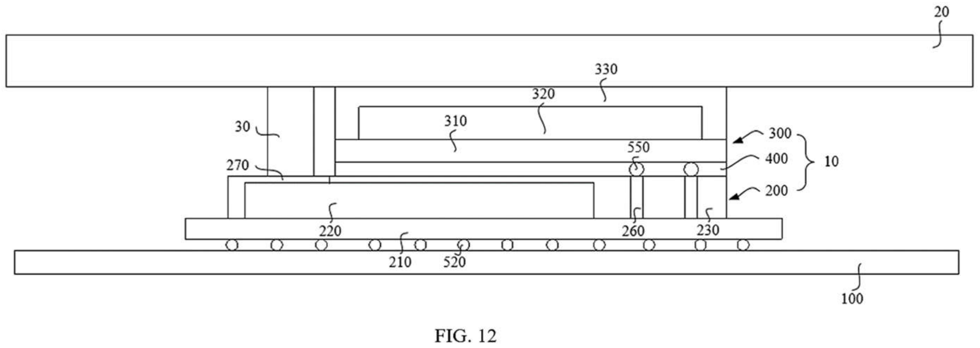

FIG. 12 is a diagram of another electronic device according to an embodiment of this application.

As shown in FIG. 12, in some examples in which the first chip 200 includes the first package structure 230, the first package structure 230 may include the first connection part 270. The thermal conduction pillar 30 is connected to the first package structure 230. Specifically, one end of the thermal conduction pillar 30 is connected to one side that is of the first package structure 230 and that is away from the second circuit board 210, to implement thermal conduction between the first die 220 and the thermal conduction pillar 30 via the first package structure 230.

In this way, the thermal conduction pillar 30 is disposed without affecting packaging of the first chip 200, so that the first die 220 is protected.

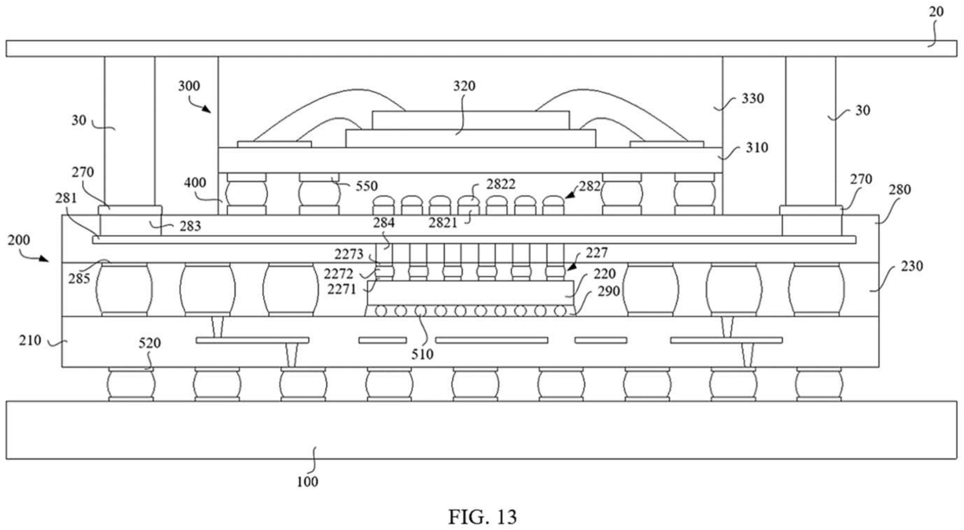

FIG. 13 is a diagram of another electronic device according to an embodiment of this application.

As shown in FIG. 13, in some possible implementations, to enable the first chip 200 to be easily connected to the second chip 300, the first chip 200 further includes a third circuit board 280. The third circuit board 280 is disposed between the first die 220 and the second chip 300. One side that is of the third circuit board 280 and that faces the second chip 300 is configured to be connected to the second chip 300. One side that is of the third circuit board 280 and that is away from the second chip 300 is configured to be connected to the second circuit board 210. A second thermal conduction structure 227 is disposed between the first die 220 and the third circuit board 280, so that the first die 220 is connected to the third circuit board 280 via the second thermal conduction structure 227, to implement thermal conduction between the first die 220 and the third circuit board 280 via the second thermal conduction structure 227. The third circuit board 280 has a first connection part 270, and the thermal conduction pillar 30 is connected to the third circuit board 280. Specifically, one end of the thermal conduction pillar 30 is connected to the side that is of the third circuit board 280 and that faces the second chip 300, to implement thermal conduction between the thermal conduction pillar 30 and the third circuit board 280, and implement thermal conduction between the first die 220 and the thermal conduction pillar 30 via the second thermal conduction structure 227 and the third circuit board 280.

In this way, the first chip 200 is connected to the second chip 300 via the third circuit board 280, so that a spacing at a joint between the first chip 200 and the second chip 300 can be small, thereby facilitating connection between the first chip 200 and the second chip 300. On the basis that the first chip 200 and the second chip 300 are conveniently connected, heat generated by the first die 220 can be transferred to the heat dissipation apparatus 20 via the second thermal conduction structure 227, the third circuit board 280, and the thermal conduction pillar 30 for heat dissipation, so that heat dissipation efficiency of the first die 220 is high.

The first connection part 270 and the second thermal conduction structure 227 may be connected via a thermal conduction body embedded in the third circuit board 280, to implement thermal conduction between the first connection part 270 and the second thermal conduction structure 227, where the thermal conduction body may be embedded in a via hole of the third circuit board 280.

For example, a fifth electrical connection terminal 285 may be disposed on the side that is of the third circuit board 280 and that is away from the second chip 300, and a projection of the fifth electrical connection terminal 285 in the thickness direction of the first chip 200 is located outside the projection of the first die 220 in the thickness direction of the first chip 200. The third circuit board 280 may be fastened to and electrically connected to the second circuit board 210 via the fifth electrical connection terminal 285.

The fifth electrical connection terminal 285 may include but is not limited to a solder ball structure, a solder pillar structure, a pin structure, or a conductive bump structure. A plurality of arrayed fifth electrical connection terminals 285 may be disposed on the side that is of the third circuit board 280 and that is away from the second chip 300.

When the first chip 200 includes the third circuit board 280, the second chip 300 may be fastened to and electrically connected to the third circuit board 280 via the third electrical connection terminal 550. Specifically, the fourth circuit board 310 may be fastened to and electrically connected to the third circuit board 280 via the third electrical connection terminal 550.

When the first chip 200 includes the third circuit board 280, the first filling medium 400 is filled between the third circuit board 280 and the second chip 300. Specifically, the first filling medium 400 is filled between the fourth circuit board 310 and the third circuit board 280.

When the first chip 200 includes the third circuit board 280, the first package structure 230 is located between the second circuit board 210 and the third circuit board 280.

For example, the thermal conduction pillar 30 may be connected to the third circuit board 280 through soldering, bonding by using a thermally conductive adhesive, or the like.

In some examples, the second thermal conduction structure 227 may include a thermal interface material filled between the first die 220 and the third circuit board 280.

In some other examples, the second thermal conduction structure 227 may include a thermal conduction gasket sandwiched between the first die 220 and the third circuit board 280.

In some other examples, the second thermal conduction structure 227 may include a first pad 2271 and a second pad 2273 disposed opposite to the first pad 2271. The first pad 2271 is disposed on a surface of the side that is of the first die 220 and that is away from the second circuit board 210, the second pad 2273 is disposed on a surface of the side that is of the third circuit board 280 and that is away from the second chip 300, the first pad 2271 is soldered to the corresponding second pad 2273 via a first solder 2272 disposed between the first pad 2271 and the second pad 2273, to implement thermal conduction between the first die 220 and the third circuit board 280 via the first pad 2271 and the second pad 2273 that are soldered.

In this way, thermal connection between the first die 220 and the third circuit board 280 is stable. In addition, thermal connection between the first die 220 and the third circuit board 280 is conveniently implemented.

For example, the first pad 2271 may be made of a metal material. For example, a material for forming the first pad 2271 may include one or more of the following: copper, silver, and aluminum.

For example, the second pad 2273 may be made of a metal material. For example, a material for forming the second pad 2273 may include one or more of the following: copper, silver, and aluminum.

For example, the first solder 2272 may be tin, or may be another solder that can be used to solder the first pad 2271 to the corresponding second pad 2273 and that has good thermal conductivity.

In some examples, at least a part of the projection of the first connection part 270 in the thickness direction of the first chip 200 is located inside the projection of the first die 220 in the thickness direction of the first chip 200.

In this way, the second thermal conduction structure 227 is conveniently connected to the first connection part 270 via the thermal conduction body embedded in the third circuit board 280. In addition, a thermal conduction path between the second thermal conduction structure 227 and the first connection part 270 may be short. This helps improve thermal conduction efficiency between the second thermal conduction structure 227 and the first connection part 270.

In some examples, the third circuit board 280 has a second thermal conduction sheet 281, and the first connection part 270 and the second thermal conduction structure 227 are both connected to the second thermal conduction sheet 281, to implement thermal conduction between the first connection part 270 and the second thermal conduction structure 227 via the second thermal conduction sheet 281. In this case, the projection of the first connection part 270 in the thickness direction of the first chip 200 may be located outside the projection of the first die 220 in the thickness direction of the first chip 200.

In this way, heat generated by the first die 220 can be transferred to the thermal conduction pillar 30 via the second thermal conduction structure 227, the second thermal conduction sheet 281, and the first connection part 270, so that when thermal conduction between the first die 220 and the thermal conduction pillar 30 is implemented via the second thermal conduction structure 227 and the third circuit board 280, thermal conduction efficiency between the first die 220 and the thermal conduction pillar 30 is high. In addition, arrangement positions of the first connection part 270 and the second thermal conduction structure 227 can be flexible.

For example, a material for forming the second thermal conduction sheet 281 may include one or more of the following: copper, silver, and aluminum.

For example, the third circuit board 280 may include at least one metal layer, and the second thermal conduction sheet 281 may be a metal sheet formed by one of metal layers of the third circuit board 280. For example, the second thermal conduction sheet 281 may be a copper sheet.

For example, the second thermal conduction sheet 281 may be a grounded metal sheet in the third circuit board 280.

For example, the second thermal conduction sheet 281 may be insulated from a grounded part in the third circuit board 280.

For example, the first connection part 270 disposed on a surface of the third circuit board 280 may be of a pad structure.

For example, the first connection part 270 is disposed on a surface of one side that is of the third circuit board 280 and that faces the second chip 300.

In this way, the thermal conduction pillar 30 can be conveniently connected to the first connection part 270.

For example, at least a part of the projection of the first connection part 270 in the thickness direction of the first chip 200 is located inside a projection of the second thermal conduction sheet 281 in the thickness direction of the first chip 200.

In this way, the first connection part 270 can be conveniently connected to the second thermal conduction sheet 281. In addition, a thermal conduction path between the first connection part 270 and the second thermal conduction sheet 281 is short, so that thermal conduction efficiency is high.

For example, at least a part of the projection of the first die 220 in the thickness direction of the first chip 200 is located inside the projection of the second thermal conduction sheet 281 in the thickness direction of the first chip 200.

In this way, the first die 220 can be conveniently connected to the second thermal conduction sheet 281 via the second thermal conduction structure 227. In addition, a thermal conduction path between the first die 220 and the second thermal conduction sheet 281 is short, so that thermal conduction efficiency is high.

In some examples, a surface of one side that is of the third circuit board 280 and that is away from the second chip 300 has the second thermal conduction sheet 281, that is, the second thermal conduction sheet 281 is formed on a metal layer on the surface that is of the third circuit board 280 and that is away from the second chip 300. The second thermal conduction sheet 281 on the surface of the side that is of the third circuit board 280 and that is away from the second chip 300 is connected to the first connection part 270 via a thermal conduction body embedded in the third circuit board 280, to implement thermal conduction between the first connection part 270 and the second thermal conduction sheet 281 on the surface of the side that is of the third circuit board 280 and that is away from the second chip 300. The second thermal conduction sheet 281 on the surface of the side that is of the third circuit board 280 and that is away from the second chip 300 may extend to the second thermal conduction structure 227, to be connected to the second thermal conduction structure 227.

In some examples, a surface of one side that is of the third circuit board 280 and that faces the second chip 300 has the second thermal conduction sheet 281, that is, the second thermal conduction sheet 281 is formed on a metal layer on the surface that is of the third circuit board 280 and that faces the second chip 300. The second thermal conduction sheet 281 on the surface of the side that is of the third circuit board 280 and that faces the second chip 300 is connected to the second thermal conduction structure 227 via a thermal conduction body embedded in the third circuit board 280, to implement thermal conduction between the second thermal conduction structure 227 and the second thermal conduction sheet 281 on the surface of the side that is of the third circuit board 280 and that faces the second chip 300. Specifically, when the second thermal conduction structure 227 includes the second pad 2273, the second thermal conduction sheet 281 on the surface of the side that is of the third circuit board 280 and that faces the second chip 300 is connected to the second pad 2273 via the thermal conduction body embedded in the third circuit board 280, to implement thermal conduction between the second pad 2273 and the second thermal conduction sheet 281 on the surface of the side that is of the third circuit board 280 and that faces the second chip 300. The second thermal conduction sheet 281 on the surface of the side that is of the third circuit board and that faces the second chip 300 may extend to the first connection part 270, to be connected to the first connection part 270.

In some other examples, the second thermal conduction sheet 281 is located at an inner layer of the third circuit board 280, that is, the second thermal conduction sheet 281 is formed on a metal layer at the inner layer of the third circuit board 280. The first connection part 270 is connected to the second thermal conduction sheet 281 via a first thermal conduction body 283 embedded in the third circuit board 280, to implement thermal conduction between the first connection part 270 and the second thermal conduction sheet 281 via the first thermal conduction body 283. The second thermal conduction structure 227 is connected to the second thermal conduction sheet 281 via a second thermal conduction body 284 embedded in the third circuit board 280, to implement thermal conduction between the second thermal conduction structure 227 and the second thermal conduction sheet 281 via the second thermal conduction body. Specifically, when the second thermal conduction structure 227 includes the second pad 2273, the second pad 2273 is connected to the second thermal conduction sheet 281 via the second thermal conduction body 284 embedded in the third circuit board 280, to implement thermal conduction between the second pad 2273 and the second thermal conduction sheet 281 via the second thermal conduction body.

In this way, the second thermal conduction sheet 281 has small impact on arrangement of structures such as a terminal and a pad on a surface of the third circuit board 280, so that impact on connection between the third circuit board 280 and the second circuit board 210 and connection between the third circuit board 280 and the second chip 300 is small.

For example, the first thermal conduction body 283 may be formed by a metal material. For example, a material for forming the first thermal conduction body 283 may include one or more of the following: copper, silver, and aluminum.

For example, the second thermal conduction body 284 may be formed by a metal material. For example, a material for forming the second thermal conduction body 284 may include one or more of the following: copper, silver, and aluminum.

That the second thermal conduction sheet 281 is located at the inner layer of the third circuit board 280 means that the second thermal conduction sheet 281 is disposed between structural layers of surfaces of the third circuit board 280 on two sides in the thickness direction. In other words, in the thickness direction of the third circuit board 280, there are structural layers of the third circuit board 280 on two sides of the second thermal conduction sheet 281.

In some examples, when the third circuit board 280 includes a plurality of metal layers, the third circuit board 280 may have a plurality of second thermal conduction sheets 281 distributed on different metal layers, and each second thermal conduction sheet 281 is connected to the first connection part 270 and the second thermal conduction structure 227, to implement thermal conduction between each second thermal conduction sheet 281 and both the first connection part 270 and the second thermal conduction structure 227. In this way, thermal conduction efficiency between the first connection part 270 and the second thermal conduction structure 227 is high.

In some possible implementations, a third thermal conduction structure 282 is disposed on the surface of the side that is of the third circuit board 280 and that faces the second chip 300, and a projection of the third thermal conduction structure 282 in the thickness direction of the first chip 200 is located inside the projection of the second chip in the thickness direction of the first chip 200.

In this way, the third thermal conduction structure 282 fills a part of a gap between the third circuit board 280 and the second chip 300. This helps improve thermal conduction efficiency between the third circuit board 280 and the second chip 300, and further improves efficiency of performing heat dissipation on the third circuit board 280 via the second chip 300.

In some examples, the third thermal conduction structure 282 and the second chip 300 are spaced apart. Specifically, the third thermal conduction structure 282 and the fourth circuit board 310 are spaced apart.

In some other examples, the third thermal conduction structure 282 is in contact with the second chip 300. Specifically, the third thermal conduction structure 292 is in contact with the fourth circuit board 310.

For example, the third thermal conduction structure 282 may include a metal pillar formed on a surface of the third circuit board 280.

For example, the third thermal conduction structure 282 includes a third pad 2821 disposed on a surface of the third circuit board 280 and a solder ball 2822 disposed on a surface of the third pad 2821. Thermal conduction between the third circuit board 280 and the solder ball 2822 disposed on the surface of the third pad 2821 is implemented via the third pad 2821.

In this way, the third pad 2821 and the solder ball 2822 disposed on the third pad 2821 occupy a small board area, so that the third thermal conduction structure 282 is disposed in a narrow space between the second chip 300 and the third circuit board 280.

For example, a plurality of arrayed third pads 2821 may be disposed on the surface of the third circuit board 280, so that solder balls 2822 disposed on surfaces of the plurality of third pads 2821 form a solder ball array.

For example, the third pad 2821 may be made of a metal material. For example, a material for forming the third pad 2821 may include one or more of the following: copper, silver, and aluminum.

For example, the solder ball may be a tin ball, or may be of a spherical structure formed by using another material with good thermal conductivity.

In some examples, a second filling medium 290 is filled between the first die 220 and the second circuit board 210, the second filling medium 290 is made of a non-conductive material, and the second filling medium 290 is configured to support the first die 220, so that the first die 220 can be stably mounted on the second circuit board 210.

For example, the second filling medium 290 may be a filling adhesive.

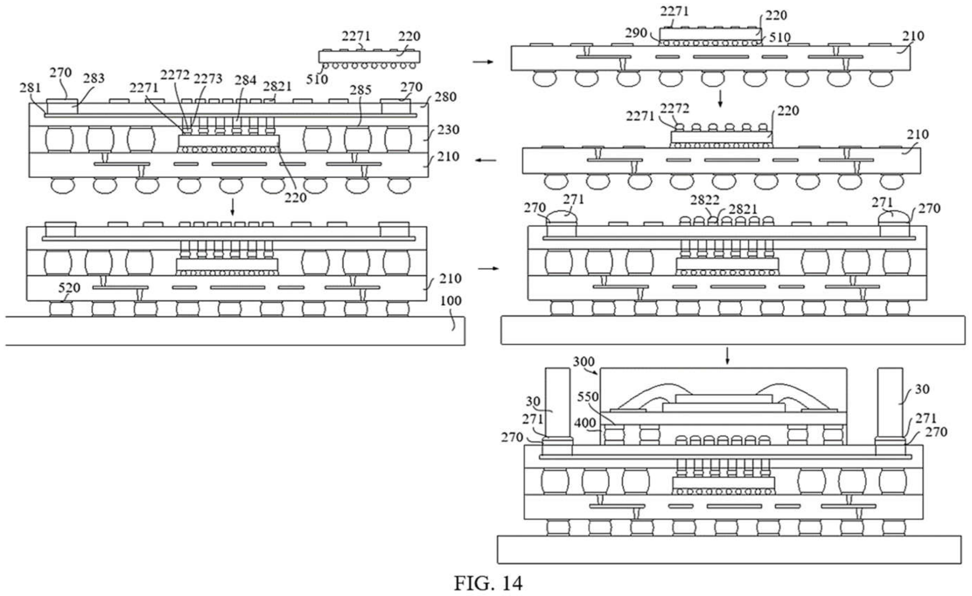

FIG. 14 is a process flowchart of a preparation method for an electronic device according to an embodiment of this application.

As shown in FIG. 14, during preparation of the electronic device, the first pad 2271 may be disposed on a back surface of the first die 220. A front surface and the back surface of the first die 220 are surfaces on two sides of the first die 220 in the thickness direction, and the front surface of the first die 220 is configured to be connected to the second circuit board 210.

For example, a first electrical connection terminal 510 is disposed on the front surface of the first die 220.

For example, the first pad 2271 may be disposed on the back surface of the first die 220 through electroplating.

After the first pad 2271 is disposed on the back surface of the first die 220, the first die 220 is disposed on the second circuit board 210, so that the front surface of the first die 220 is fastened to and electrically connected to the second circuit board 210.

For example, the first die 220 is fastened to and electrically connected to the second circuit board 210 via the first electrical connection terminal 510, and the second filling medium 290 is filled between the first die 220 and the second circuit board 210.

For example, the second electrical connection terminal 520 is disposed on the side that is of the second circuit board 210 and that is away from the first die 220.

After the first die 220 is disposed on the second circuit board 210, the first solder 2272 is sprayed on the surface of the first pad 2271.

After the first solder 2272 is sprayed on the surface of the first pad 2271, the third circuit board 280 is disposed on the side that is of the first die 220 and that is away from the second circuit board 210, so that the third circuit board 280 is fastened to and electrically connected to the second circuit board 210, the first pad 2271 is soldered to the corresponding second pad 2273 via the first solder 2272 sprayed on the surface, and a packaging material is injected between the second circuit board 210 and the third circuit board 280 to form the first package structure 230. The second pad 2273 corresponding to the first pad 2271 is disposed on the side that is of the third circuit board 280 and that faces the first die 220, and the first connection part 270 and the third pad 2821 are disposed on the side that is of the third circuit board 280 and that is away from the first die 220.

For example, the fifth electrical connection terminal 285 is disposed on the surface of the third circuit board 280, so that the third circuit board 280 is fastened to and electrically connected to the second circuit board 210 via the fifth electrical connection terminal 285.

After the third circuit board 280 is disposed on the side that is of the first die 220 and that is away from the second circuit board 210, the side that is of the second circuit board 210 and that is away from the first die 220 is fastened to and electrically connected to the first circuit board 100.

For example, the second circuit board 210 is fastened to and electrically connected to the first circuit board 100 via the second electrical connection terminal 520.

After the side that is of the second circuit board 210 and that is away from the first die 220 is fastened to and electrically connected to the first circuit board 100, the second solder 271 is sprayed on surfaces of the first connection part 270 and the third pad 2821, and the solder ball 2822 is disposed on the surface of the third pad 2821 via the second solder 271 sprayed on the surface of the third pad 2821.

After the second solder 271 is sprayed on the surface of the first connection part 270 and the solder ball 2822 is disposed on the surface of the third pad 2821, the second chip 300 and the thermal conduction pillar 30 are disposed on the side that is of the third circuit board 280 and that is away from the first die 220, so that the second chip 300 is fastened to and electrically connected to the third circuit board 280, and the thermal conduction pillar 30 is soldered to the first connection part 270 via the second solder 271 sprayed on the surface of the first connection part 270; and the first filling medium 400 is filled between the second chip 300 and the third circuit board 280.

For example, the second chip 300 and the thermal conduction pillar 30 may be disposed on the side that is of the third circuit board 280 and that is away from the first die 220 through reflow soldering, and the second chip 300 and the thermal conduction pillar 30 may be soldered and formed on the surface of the third circuit board 280 at a time.

After the second chip 300 and the thermal conduction pillar 30 are disposed on the side that is of the third circuit board 280 and that is away from the first die 220, the side that is of the second chip 300 and that is away from the third circuit board 280 and the end that is of the thermal conduction pillar 30 and that is away from the third circuit board 280 are connected to the heat dissipation apparatus 20.

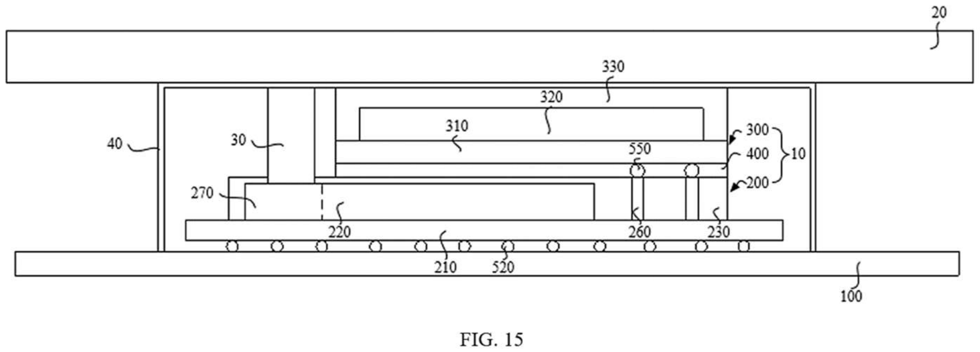

FIG. 15 is a diagram of another electronic device according to an embodiment of this application.

As shown in FIG. 15, in some possible implementations, the electronic device further includes a shielding cover 40. The shielding cover 40 is mounted on the first circuit board 100, and the heat dissipation apparatus 20 is disposed on one side that is of the shielding cover 40 and that is away from the first circuit board 100. A mounting space is formed between the shielding cover 40 and the first circuit board 100, and the first chip 200 and the second chip 300 are both disposed in the mounting space. The shielding cover 40 can perform electromagnetic shielding on the first chip 200 and the second chip 300, and therefore can reduce electromagnetic interference caused by a component outside the shielding cover 40 to the first chip 200 and the second chip 300.

In some examples in which the electronic device further includes the shielding cover 40, the shielding cover 40 is connected to the heat dissipation apparatus 20, so that thermal conduction between the shielding cover 40 and the heat dissipation apparatus 20 is implemented, and a component like the package assembly 10 in the shielding cover 40 can dissipate heat via the shielding cover 40.

In some examples in which the electronic device further includes the shielding cover 40, the side that is of the second chip 300 and that is away from the first circuit board 100 is connected to the shielding cover 40, so that the second chip 300 is connected to the heat dissipation apparatus 20 via the shielding cover 40, to implement thermal conduction between the second chip 300 and the heat dissipation apparatus 20 via the shielding cover 40.

For example, the side that is of the second chip 300 and that is away from the first circuit board 100 may be connected to the shielding cover 40 via a thermal interface material, and the shielding cover 40 may also be connected to the heat dissipation apparatus 20 via the thermal interface material, so that thermal conductivity between the second chip 300 and the heat dissipation apparatus 20 is good.

In some examples in which the electronic device further includes the shielding cover 40, the thermal conduction pillar 30 is disposed in the mounting space, and the end that is of the thermal conduction pillar 30 and that is away from the first chip 200 is connected to the shielding cover 40, so that the thermal conduction pillar 30 is connected to the heat dissipation apparatus 20 via the shielding cover 40, to implement thermal conduction between the thermal conduction pillar 30 and the heat dissipation apparatus 20 via the shielding cover 40.

In this way, the shielding cover 40 has good shielding effect on a component in the mounting space. In addition, the thermal conduction pillar 30 is assembled easily.

For example, the end that is of the thermal conduction pillar 30 and that is away from the first chip 200 may be connected to the shielding cover 40 via the thermal interface material.

For example, one end of the thermal conduction pillar 30 is connected to the shielding cover 40, and the other end of the thermal conduction pillar 30 is connected to the first die 220.

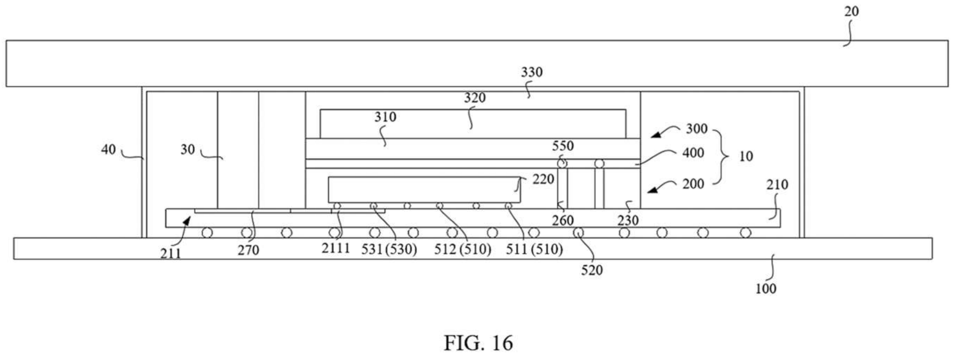

FIG. 16 is a diagram of another electronic device according to an embodiment of this application.

As shown in FIG. 16, one end of the thermal conduction pillar 30 is connected to the shielding cover 40, and the other end of the thermal conduction pillar 30 is connected to the first thermal conduction sheet 211.

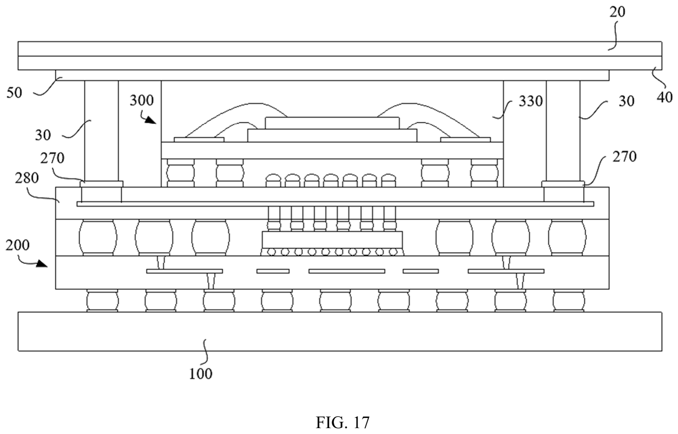

FIG. 17 is a diagram of another electronic device according to an embodiment of this application.

As shown in FIG. 17, for example, one end of the thermal conduction pillar 30 is connected to the shielding cover 40, and the other end of the thermal conduction pillar 30 is connected to the third circuit board 280. There is a thermal interface material 50 between the thermal conduction pillar 30 and the second chip 300 and the shielding cover 40, for example, the thermal interface material 50 may be a thermal adhesive. The thermal conduction pillar 30 and the second chip 300 are connected to the shielding cover 40 via the thermal interface material 50.

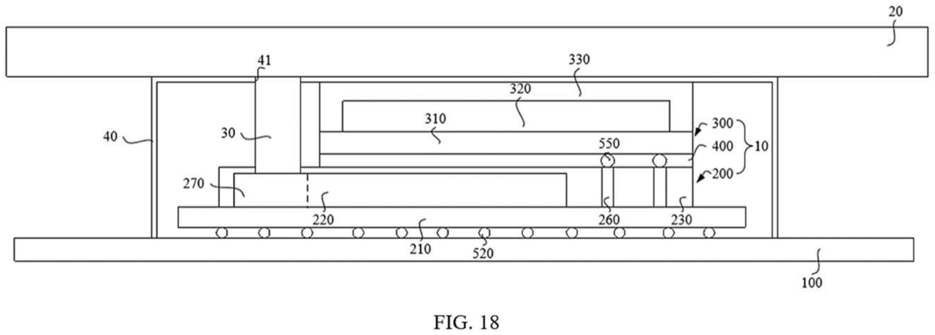

FIG. 18 is a diagram of another electronic device according to an embodiment of this application.

As shown in FIG. 18, in some examples in which the electronic device further includes the shielding cover 40, the shielding cover 40 has a through hole 41 communicating the mounting space with the outside of the shielding cover 40, and the thermal conduction pillar 30 passes through the through hole 41. The end that is of the thermal conduction pillar 30 and that is away from the first circuit board 100 is connected to the heat dissipation apparatus 20 outside the shielding cover 40.

In this way, thermal conduction efficiency between the thermal conduction pillar 30 and the heat dissipation apparatus 20 is high, so that heat dissipation efficiency of the first chip 200 is high.

For example, the end that is of the thermal conduction pillar 30 and that is away from the first circuit board 100 may be connected to the heat dissipation apparatus 20 via a thermal interface material.

For example, one end of the thermal conduction pillar 30 is connected to the heat dissipation apparatus 20, and the other end of the thermal conduction pillar 30 is connected to the first die 220.

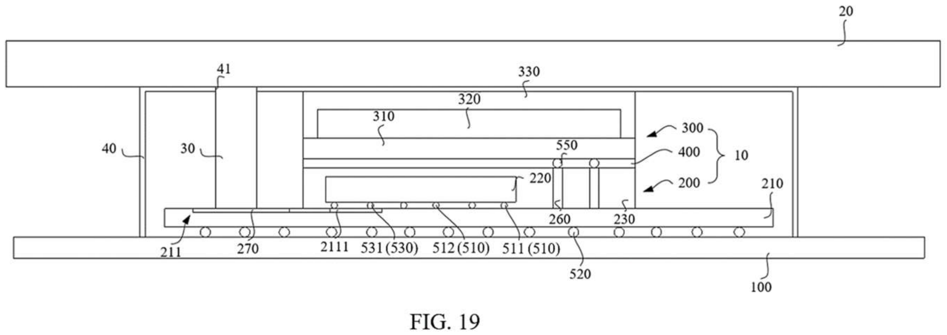

FIG. 19 is a diagram of another electronic device according to an embodiment of this application.

As shown in FIG. 19, for example, one end of the thermal conduction pillar 30 is connected to the heat dissipation apparatus 20, and the other end of the thermal conduction pillar 30 is connected to the first thermal conduction sheet 211.

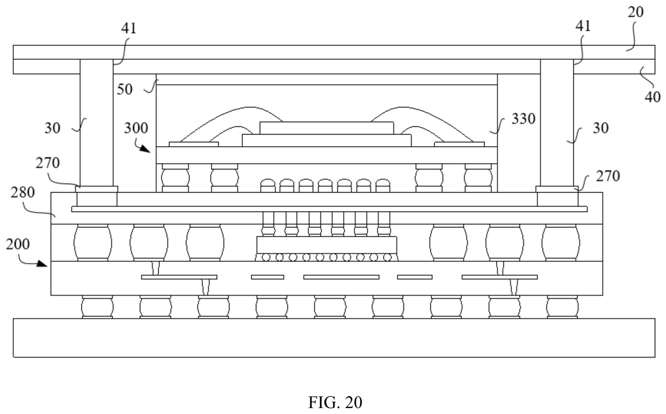

FIG. 20 is a diagram of another electronic device according to an embodiment of this application.

As shown in FIG. 20, one end of the thermal conduction pillar 30 is connected to the heat dissipation apparatus 20, and the other end of the thermal conduction pillar 30 is connected to the third circuit board 280.

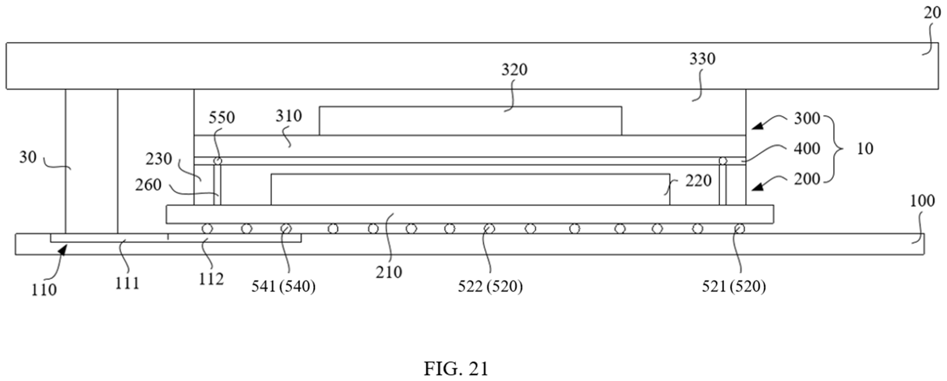

FIG. 21 is a diagram of another electronic device according to an embodiment of this application.

As shown in FIG. 21, in some possible implementations, the electronic device includes the thermal conduction pillar 30. The thermal conduction pillar 30 and the package assembly 10 are of a split structure. The thermal conduction pillar 30 and the package assembly 10 are located on a same side of the first circuit board 100, and a projection of the thermal conduction pillar 30 in a thickness direction of the first circuit board 100 is located outside a projection of the package assembly 10 in the thickness direction of the first circuit board 100. The thermal conduction pillar 30 is disposed between the first circuit board 100 and the heat dissipation apparatus 20.

The first circuit board 100 has the third thermal conduction sheet 110. The third thermal conduction sheet 110 has the third connection part 111 and the fourth connection part 112. A projection of the third connection part 111 in the thickness direction of the first circuit board 100 is located outside the projection of the package assembly 10 in the thickness direction of the first circuit board 100, and a projection of the fourth connection part 112 in the thickness direction of the first circuit board 100 is located inside the projection of the first chip 200 in the thickness direction of the first circuit board 100. One end of the thermal conduction pillar 30 is connected to the third connection part 111, to implement thermal conduction between the thermal conduction pillar 30 and the third thermal conduction sheet 110. The other end of the thermal conduction pillar 30 is connected to the heat dissipation apparatus 20, to implement thermal conduction between the thermal conduction pillar 30 and the heat dissipation apparatus 20. The fourth connection part 112 is connected to the first chip 200, to implement thermal conduction between the third thermal conduction sheet 110 and the first chip 200, and implement thermal conduction between the first chip 200 and the heat dissipation apparatus 20 via the third thermal conduction sheet 110 and the thermal conduction pillar 30.

In this way, the third thermal conduction sheet 110, the thermal conduction pillar 30, and the heat dissipation apparatus 20 between which thermal conduction between is implemented form a heat dissipation path of the first chip 200, so that heat generated by the first chip 200 can be transferred to the heat dissipation apparatus 20 via the third thermal conduction sheet 110 and the thermal conduction pillar 30 for heat dissipation. Compared with a heat dissipation path in which the first chip 200 transfers the heat to the heat dissipation apparatus 20 via the second chip 300, the heat dissipation path formed by the third thermal conduction sheet 110 and the thermal conduction pillar 30 has lower thermal resistance. Compared with the first circuit board 100, the heat dissipation apparatus 20 has higher heat dissipation efficiency, and therefore the first chip 200 has higher heat dissipation efficiency. This helps improve heat dissipation efficiency of the package assembly 10, and can further reduce a limitation on performance of the package assembly 10 caused by low heat dissipation efficiency. In addition, the thermal conduction pillar 30 is connected to the first circuit board 100, so that the thermal conduction pillar 30 is easily connected. In addition, the thermal conduction pillar 30 may be disposed without affecting packaging of the package assembly 10.

When the first chip 200 includes the second circuit board 210 and the first die 220, the projection of the fourth connection part 112 in the thickness direction of the first circuit board 100 is located inside a projection of the second circuit board 210 in the thickness direction of the first circuit board 100, and the fourth connection part 112 is connected to the second circuit board 210, so that thermal conduction between the first die 220 and the third thermal conduction sheet 110 is implemented via the second circuit board 210, and heat generated by the first die 220 can be transferred to the heat dissipation apparatus 20 via the second circuit board 210, the third thermal conduction sheet 110, and the thermal conduction pillar 30.

For example, the thermal conduction pillar 30 may be disposed on one or more sides of the package assembly 10. For example, the thermal conduction pillars 30 may be disposed on any two sides of the package assembly 10, or the thermal conduction pillars 30 may be disposed around the package assembly 10. Positions, lengths and widths, and a quantity of the thermal conduction pillars 30 disposed on the first circuit board 100 may be determined based on a layout of the first circuit board 100.

For example, a material for forming the third thermal conduction sheet 110 may include one or more of the following: copper, silver, and aluminum.

For example, the first circuit board 100 may include at least one metal layer, and the third thermal conduction sheet 110 may be a metal sheet formed by one of metal layers of the first circuit board 100. For example, the third thermal conduction sheet 110 may be a copper sheet.

For example, the third thermal conduction sheet 110 may be a grounded metal sheet in the first circuit board 100.

For example, the third thermal conduction sheet 110 may alternatively be insulated from a grounded part in the first circuit board 100.

For example, the thermal conduction pillar 30 may be connected to the third thermal conduction sheet 110 through soldering, bonding by using a thermally conductive adhesive, or the like.

For example, the fourth connection part 112 may be connected to the first chip 200 through bonding by using a thermally conductive adhesive. Specifically, the fourth connection part 112 may be connected to the second circuit board 210 through bonding by using a thermally conductive adhesive.

In some possible implementations, a surface of one side that is of the first circuit board 100 and that is configured to mount the first chip 200 has the third thermal conduction sheet 110. In other words, the third thermal conduction sheet 110 is formed on a metal layer at a surface layer of the first circuit board 100.

In this way, the thermal conduction pillar 30 and the first chip 200 can be conveniently connected to the third thermal conduction sheet 110 located on the surface of the first circuit board 100. In addition, a thermal conduction path of the thermal conduction pillar 30, the first chip 200, and the third thermal conduction sheet 110 located on the surface of the first circuit board 100 is also short, so that the first chip 200 has high heat dissipation efficiency in performing heat dissipation via the thermal conduction pillar 30.

When the first circuit board 100 includes a plurality of metal layers, the first circuit board 100 may have a plurality of third thermal conduction sheets 110 distributed on different metal layers, and thermal conduction between the plurality of third thermal conduction sheets 110 distributed on the different metal layers may be implemented via a thermal conduction structure passing through a via hole in the first circuit board 100.

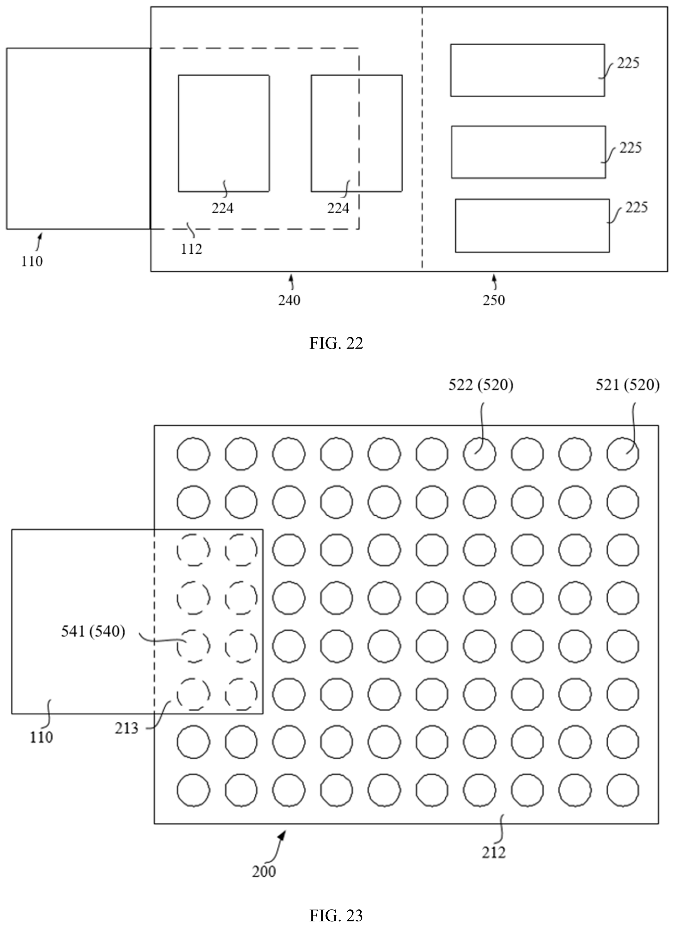

FIG. 22 is a diagram of cooperation between a first chip and a third thermal conduction sheet of an electronic device according to an embodiment of this application.

As shown in FIG. 22, with reference to FIG. 21, the first chip 200 may include a third part 240 and a fourth part 250. The third part 240 includes a first core 224, and the fourth part 250 includes a second core 225.

For example, the third part 240 may include a plurality of first cores 224.

For example, the fourth part 250 may include a plurality of second cores 225.

In some examples in which the first circuit board 100 includes the third thermal conduction sheet 110, a projection of the fourth connection part 112 in the thickness direction of the first circuit board 100 is located inside a projection of the third part 240 in the thickness direction of the first circuit board 100, and the projection of the fourth connection part 112 in the thickness direction of the first circuit board 100 is located outside a projection of the fourth part 250 in the thickness direction of the first circuit board 100.

In this way, the first core 224 with higher power is disposed close to the fourth connection part 112, and a thermal conduction path between the first core 224 and the third thermal conduction sheet 110 is short, so that a large amount of heat generated when the first core 224 runs is efficiently dissipated via the third thermal conduction sheet 110 and the thermal conduction pillar 30, and the first chip 200 and the package assembly 10 have low overheating risk.

FIG. 23 is a diagram of cooperation between a first chip and a third thermal conduction sheet of another electronic device according to an embodiment of this application.

As shown in FIG. 23, with reference to FIG. 21, in some possible implementations, one side that is of the first chip 200 and that faces the first circuit board 100 includes a second electrical connection region 212 and a second thermal conduction region 213. Specifically, one side that is of the second circuit board 210 and that faces the first circuit board 100 includes the second electrical connection region 212 and the second thermal conduction region 213. A projection of the second electrical connection region 212 in the thickness direction of the first circuit board 100 is located outside a projection of the third thermal conduction sheet 110 in the thickness direction of the first circuit board 100, and a projection of the second thermal conduction region 213 in the thickness direction of the first circuit board 100 is located inside the projection of the third thermal conduction sheet 110 in the thickness direction of the second circuit board 210.

A plurality of second electrical connection terminals 520 disposed on the side that is of the first chip 200 and that faces the second circuit board 210 include a second power terminal 521 and a second signal terminal 522. The second power terminal 521 and the second signal terminal 522 are both located in the second electrical connection region 212. In other words, the second power terminal 521 and the second signal terminal 522 are not disposed in the second thermal conduction region 213. The first chip 200 is electrically connected to the first circuit board 100 via the second power terminal 521 and the second signal terminal 522. Specifically, the second circuit board 210 is electrically connected to the first circuit board 100 via the second power terminal 521 and the second signal terminal 522.

A fourth thermal conduction structure 540 is disposed between the first chip 200 and the fourth connection part 112, and the first chip 200 is connected to the fourth connection part 112 via the fourth thermal conduction structure 540. Specifically, the fourth thermal conduction structure 540 is disposed between the second thermal conduction region 213 and the fourth connection part 112. The second thermal conduction region 213 is connected to the fourth connection part 112 via the fourth thermal conduction structure 540, to implement thermal conduction between the second circuit board 210 and the third thermal conduction sheet 110 via the fourth thermal conduction structure 540.

In this way, the first chip 200 is electrically connected to the first circuit board 100 having the third thermal conduction sheet 110, and the third thermal conduction sheet 110 has small impact on current and signal transmission between the first circuit board 100 and the first chip 200. In addition, the second power terminal 521 and the second signal terminal 522 are both disposed outside an overlapping region between the first chip 200 and the third thermal conduction sheet 110. This facilitates arrangement of a finished third thermal conduction sheet 110 with a large size and good integrity, so that thermal conduction efficiency of the third thermal conduction sheet 110 is high.

The second power terminal 521 is a terminal for power supply between the second circuit board 210 and the first circuit board 100, and the second signal terminal 522 is a terminal for signal transmission between the second circuit board 210 and the first circuit board 100.

An edge of one side of the second thermal conduction region 213 at least partially overlaps with an edge of one side of the second circuit board 210. In other words, the second electrical connection region 212 is not disposed on at least one side of the second thermal conduction region 213.

For example, a material for forming the fourth thermal conduction structure 540 may include one or more of the following: copper, silver, and aluminum.

In some examples, the fourth thermal conduction structure 540 may include a thermal interface material filled between the second thermal conduction region 213 and the fourth connection part 112.

In some other examples, the fourth thermal conduction structure 540 may include a thermal conduction gasket sandwiched between the second thermal conduction region 213 and the fourth connection part 112.

In some other examples, the fourth thermal conduction structure 540 may include a terminal disposed in the second thermal conduction region 213. The terminal disposed in the second thermal conduction region 213 may be disabled, to avoid a short circuit caused by connection between the terminal disposed in the second thermal conduction region 213 and the third thermal conduction sheet 110. In this way, the terminal disposed in the second thermal conduction region 213 can be connected to the third thermal conduction sheet 110, to transfer the heat of the first chip 200 to the third thermal conduction sheet 110. In this way, the terminal in the second thermal conduction region 213 can be used to thermally connect the first chip 200 to the third thermal conduction sheet 110, so that a connection structure between the first chip 200 and the third thermal conduction sheet 110 is simple.

In some possible implementations, the third thermal conduction sheet 110 is made of a conductive material, the fourth thermal conduction structure 540 includes a second ground terminal 541 disposed on the side that is of the first chip 200 and that faces the first circuit board 100. Specifically, the second ground terminal 541 is disposed on the side that is of the second circuit board 210 and that faces the first circuit board 100. A projection of the second ground terminal 541 in the thickness direction of the first circuit board 100 is located inside the projection of the fourth connection part 112 in the thickness direction of the first circuit board 100, and the first chip 200 is electrically connected to the fourth connection part 112 via the second ground terminal 541.

In this way, the second ground terminal 541 can be used for thermal conduction between the first chip 200 and the third thermal conduction sheet 110, and can be further used for grounding of the first chip 200, so that utilization of the terminal disposed on the first chip 200 is high.

For example, the fourth thermal conduction structure 540 may be located at an edge of one side that is at least partially overlapped with the first chip 200 and the second thermal conduction region 213.

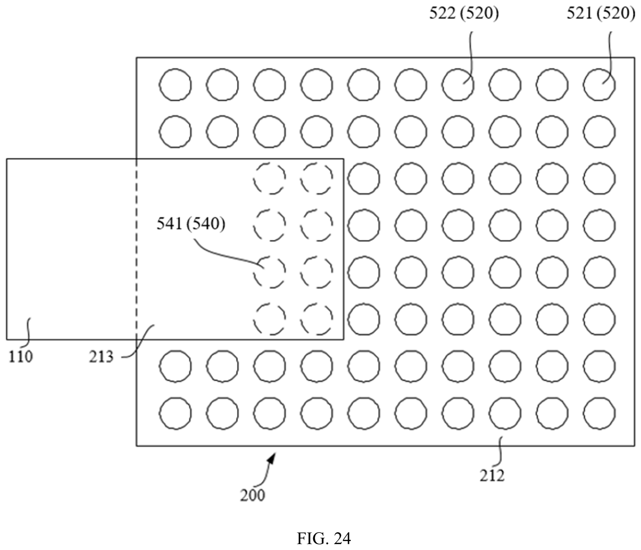

FIG. 24 is a diagram of cooperation between a first chip and a third thermal conduction sheet of another electronic device according to an embodiment of this application.

As shown in FIG. 24, in some examples, the fourth thermal conduction structure 540 may not be located on the edge of the side that is at least partially overlapped with the first chip 200 and the second thermal conduction region 213, and all other terminals except the fourth thermal conduction structure 540 may be cleared in the second thermal conduction region 213.

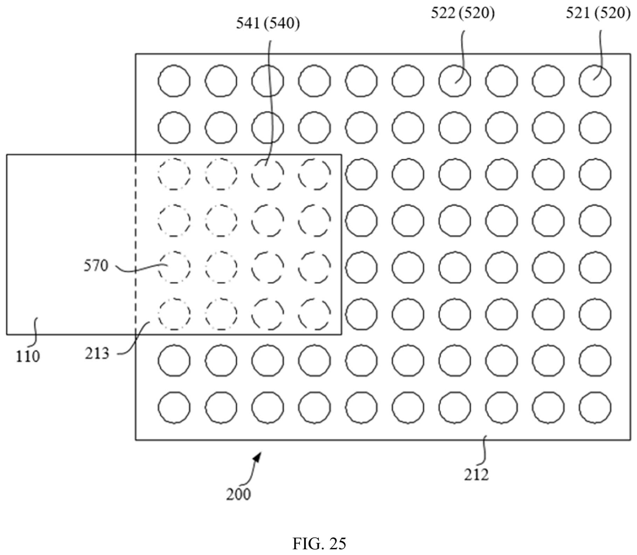

FIG. 25 is a diagram of cooperation between a first chip and a third thermal conduction sheet of another electronic device according to an embodiment of this application.

As shown in FIG. 25, in some examples, a second connection terminal 570 whose current interaction function is disabled is further disposed on the side that is of the first chip 200 and that faces the first circuit board 100. In other words, there is no current input or output in the second connection terminal 570. The fourth thermal conduction structure 540 may further include the second connection terminal 570. The second connection terminal 570 may connect the fourth connection part 112 to the second thermal conduction region 213, to implement thermal conduction between the first chip 200 and the third thermal conduction sheet 110 via the second connection terminal 570. In this way, the first chip 200 and the first circuit board 100 can be stably connected.

In some examples, the second connection terminal 570 and the third thermal conduction sheet 110 may be spaced apart, so that the second connection terminal 570 is insulated from the third thermal conduction sheet 110.

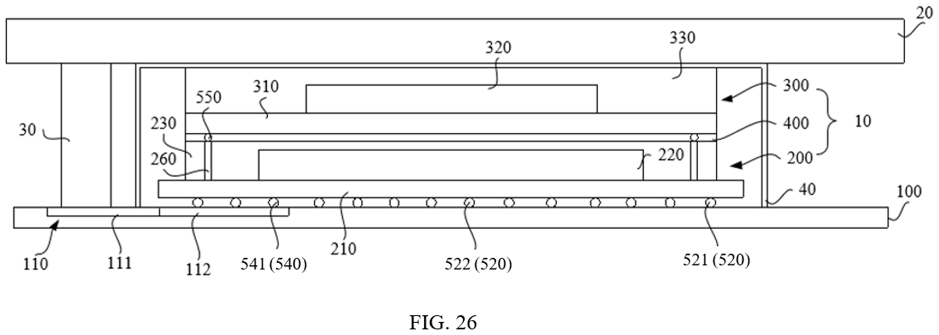

FIG. 26 is a diagram of another electronic device according to an embodiment of this application.

As shown in FIG. 26, in some examples in which the electronic device further includes the shielding cover 40, the thermal conduction pillar 30 connected to the third thermal conduction sheet 110 may be disposed outside the shielding cover 40, and the thermal conduction pillar 30 is connected to the heat dissipation apparatus 20 outside the shielding cover 40.

In this way, the thermal conduction pillar 30 does not affect disposing of the shielding cover 40, and the thermal conduction pillar 30 and the shielding cover 40 are both conveniently mounted.

In some examples, the thermal conduction pillar 30 may be of an integrated structure.

In some examples, the thermal conduction pillar 30 may be of a spliced structure formed by splicing a plurality of segments. In other words, the thermal conduction pillar 30 includes a plurality of thermally conductive segments sequentially spliced. For example, when one side surface of one end that is of the thermal conduction pillar 30 and that is connected to the first connection part 270 is covered by the first package structure 230, a part that is covered by the first package structure 230 and that is on the side surface may be a thermally conductive segment, and a part that is not covered by the first package structure 230 and that is on the side surface may be another thermally conductive segment.

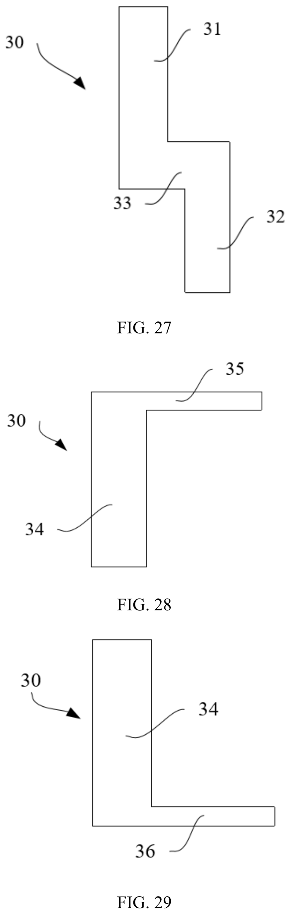

FIG. 27 is a diagram of a thermal conduction pillar according to an embodiment of this application.

As shown in FIG. 27, the thermal conduction pillar 30 may include a first segment 31, a second segment 32, and a third segment 33. The first segment 31 and the second segment 32 are staggered in a length direction or a width direction of the first chip 200. One end of the first segment 31 is configured to be connected to the heat dissipation apparatus 20, to implement thermal conduction between the first segment 31 and the heat dissipation apparatus 20. The other end of the first segment 31 is connected to one end of the second segment 32 via the third segment 33. The other end of the second segment 32 is configured to be connected to the first chip 200, to implement thermal conduction between the second segment 32 and the first chip 200.

In this way, the first segment 31 and the second segment 32 that are staggered can avoid another component in the electronic device, so that the thermal conduction pillar 30 is disposed flexibly. In addition, the thermal conduction pillar 30 has a large surface area, so that the thermal conduction pillar 30 can have high heat dissipation efficiency through a surrounding environment.

FIG. 28 is a diagram of another thermal conduction pillar according to an embodiment of this application.

As shown in FIG. 28, the thermal conduction pillar 30 may include a fourth segment 34 and a fifth segment 35. One end of the fourth segment 34 is configured to be connected to the first chip 200, to implement thermal conduction between the fourth segment 34 and the first chip 200. The other end of the fourth segment 34 is connected to one end of the fifth segment 35. The other end of the fifth segment 35 is configured to be connected to the heat dissipation apparatus 20, to implement thermal conduction between the fifth segment 35 and the heat dissipation apparatus 20. An area of a cross section of the fifth segment 35 is greater than an area of a cross section of the fourth segment 34. The cross section of the fifth segment 35 is perpendicular to an axial direction of the fifth segment 35, and the cross section of the fourth segment 34 is perpendicular to an axial direction of the fourth segment.

In this way, heat exchange efficiency between the thermal conduction pillar 30 and the heat dissipation apparatus 20 can be high.

FIG. 29 is a diagram of another thermal conduction pillar according to an embodiment of this application.

As shown in FIG. 29, the thermal conduction pillar 30 may include a fourth segment 34 and a sixth segment 36. One end of the fourth segment 34 is configured to be connected to the heat dissipation apparatus 20, to implement thermal conduction between the fourth segment 34 and the heat dissipation apparatus 20. The other end of the fourth segment 34 is connected to one end of the sixth segment 36. The other end of the sixth segment 36 is configured to be connected to the first chip 200, to implement thermal conduction between the sixth segment 36 and the first chip 200. An area of a cross section of the sixth segment 36 is greater than an area of a cross section of the fourth segment 34. The cross section of the sixth segment 36 is perpendicular to an axial direction of the sixth segment 36, and the cross section of the fourth segment 34 is perpendicular to an axial direction of the fourth segment.

In this way, heat exchange efficiency between the thermal conduction pillar 30 and the first chip 200 can be high.

In the descriptions of embodiments of this application, it should be noted that, unless otherwise clearly specified and limited, the term "mounting", "connection to", or "connection" should be understood in a broad sense, for example, may be fastening, or may be an indirect connection through an intermediate medium, or may be an internal communication between two elements or an interaction relationship between two elements. A person of ordinary skill in the art may understand specific meanings of the foregoing terms in embodiments of this application based on specific cases.

An apparatus or element in embodiments of this application or an implied apparatus or element needs to have a specific orientation and be constructed and operated in a specific orientation, and therefore cannot be construed as a limitation on embodiments of this application. In the description of embodiments of this application, unless otherwise exactly and specifically ruled, "a plurality of" means two or more than two.

In the specification, claims, and accompanying drawings of embodiments of this application, the terms "first", "second", "third", "fourth", and the like (if existent) are intended to distinguish between similar objects but do not necessarily indicate a specific order or sequence. It may be understood that the data used in such a way is interchangeable in proper circumstances, so that embodiments of this application described herein can be implemented in other sequences than the sequence illustrated or described herein. In addition, the terms "include" and "have" and any other variants are intended to cover the non-exclusive inclusion. For example, a process, method, system, product, or device that includes a list of steps or units is not necessarily limited to those expressly listed steps or units, but may include other steps or units not expressly listed or inherent to such a process, method, product, or device.

The term "a plurality of" in this specification refers to two or more. The term "and/or" in this specification describes only an association relationship for describing associated objects and represents that three relationships may exist. For example, A and/or B may represent the following three cases: Only A exists, both A and B exist, and only B exists. In addition, a character "/" in this specification usually indicates an "or" relationship between associated objects, and a character "/" in a formula usually indicates a "divisible" relationship between associated objects.

It may be understood that various numbers in embodiments of this application are merely used for differentiation for ease of description, and are not used to limit the scope of embodiments of this application.

It should be understood that sequence numbers of the foregoing processes do not mean execution sequences in embodiments of this application. The execution sequences of the processes should be determined according to functions and internal logic of the processes, and should not be construed as any limitation on the implementation processes of embodiments of this application.

## Claims

1. A package assembly, comprising a first chip, a second chip, and a thermal conduction pillar, wherein
the second chip is disposed on one side of the first chip in a thickness direction, the other side of the first chip in the thickness direction is configured to be connected to a first circuit board, and the second chip is configured to be connected to a heat dissipation apparatus disposed on one side that is of the second chip and that is away from the first chip, so that the second chip is configured for thermal conduction with the heat dissipation apparatus; and
the first chip has a first connection part, and a projection of the first connection part in the thickness direction of the first chip is located outside a projection of the second chip in the thickness direction of the first chip; one end of the thermal conduction pillar is connected to the first connection part, to implement thermal conduction between the thermal conduction pillar and the first chip; and the other end of the thermal conduction pillar protrudes from a surface of one side that is of the first chip and that faces the second chip, and is configured to be connected to the heat dissipation apparatus, to implement thermal conduction between the thermal conduction pillar and the heat dissipation apparatus.

2. The package assembly according to claim 1, wherein the first chip comprises a second circuit board and a die;
the die is disposed on one side of the second circuit board in a thickness direction, the other side of the second circuit board in the thickness direction is configured to be connected to the first circuit board, and the second chip is disposed on one side that is of the die and that is away from the second circuit board;
the second circuit board has a first thermal conduction sheet, the first thermal conduction sheet has the first connection part and a second connection part, a projection of the first connection part in the thickness direction of the second circuit board is located outside a projection of the die in the thickness direction of the second circuit board, and a projection of the second connection part in the thickness direction of the second circuit board is located inside the projection of the die in the thickness direction of the second circuit board; and
the thermal conduction pillar is connected to the first thermal conduction sheet, to implement thermal conduction between the thermal conduction pillar and the first thermal conduction sheet, and the second connection part is connected to the die, to implement thermal conduction between the first thermal conduction sheet and the die.

3. The package assembly according to claim 2, wherein one side that is of the die and that faces the second circuit board comprises a first electrical connection region, and a projection of the first electrical connection region in the thickness direction of the second circuit board is located outside a projection of the first thermal conduction sheet in the thickness direction of the second circuit board;
a first power terminal and a first signal terminal are disposed on the side that is of the die and that faces the second circuit board, the first power terminal and the first signal terminal are both located inside the first electrical connection region, and the die is electrically connected to the second circuit board via the first power terminal and the first signal terminal; and
a first thermal conduction structure is disposed between the die and the second connection part, and the die is connected to the second connection part via the first thermal conduction structure, to implement thermal conduction between the die and the first thermal conduction sheet via the first thermal conduction structure.

4. The package assembly according to claim 3, wherein the first thermal conduction sheet is made of a conductive material, the first thermal conduction structure comprises a first ground terminal disposed on the side that is of the die and that faces the second circuit board, a projection of the first ground terminal in the thickness direction of the second circuit board is located inside the projection of the second connection part in the thickness direction of the second circuit board, and the die is electrically connected to the second connection part via the first ground terminal.

5. The package assembly according to any one of claims 2 to 4, wherein a surface of one side that is of the second circuit board and that is configured to mount the die has the first thermal conduction sheet.

6. The package assembly according to any one of claims 2 to 5, wherein the die comprises a first part and a second part, the first part comprises a first core, the second part comprises a second core, and power of the first core is higher than power of the second core; and
the projection of the second connection part in the thickness direction of the second circuit board is located inside a projection of the first part in the thickness direction of the second circuit board, and the projection of the second connection part in the thickness direction of the second circuit board is located outside a projection of the second part in the thickness direction of the second circuit board.

7. The package assembly according to claim 1, wherein the first chip comprises a second circuit board and a die;
the die is disposed on one side of the second circuit board in a thickness direction, the other side of the second circuit board in the thickness direction is configured to be connected to the first circuit board, and the second chip is disposed on one side that is of the die and that is away from the second circuit board; and
the die has the first connection part, and the thermal conduction pillar is connected to the die, to implement thermal conduction between the thermal conduction pillar and the die.

8. The package assembly according to claim 7, wherein the die comprises a first part and a second part, the first part comprises a first core, the second part comprises a second core, power of the first core is higher than power of the second core, and the first part has the first connection part.

9. The package assembly according to claim 1, wherein the first chip comprises a second circuit board, a die, and a third circuit board;
the die is disposed on one side of the second circuit board in a thickness direction, the other side of the second circuit board in the thickness direction is configured to be connected to the first circuit board, and the second chip is disposed on one side that is of the die and that is away from the second circuit board;
the third circuit board is disposed between the die and the second chip, one side that is of the third circuit board and that faces the second chip is connected to the second chip, and one side that is of the third circuit board and that is away from the second chip is connected to the second circuit board;
a second thermal conduction structure is disposed between the die and the third circuit board, and the die is connected to the third circuit board via the second thermal conduction structure, to implement thermal conduction between the die and the third circuit board via the second thermal conduction structure; and
the third circuit board has the first connection part, and the thermal conduction pillar is connected to the third circuit board, to implement thermal conduction between the thermal conduction pillar and the third circuit board.

10. The package assembly according to claim 9, wherein the second thermal conduction structure comprises a first pad and a second pad disposed opposite to the first pad; and
the first pad is disposed on a surface of the side that is of the die and that is away from the second circuit board, the second pad is disposed on a surface of the side that is of the third circuit board and that is away from the second chip, the first pad is soldered to the corresponding second pad via a solder disposed between the first pad and the second pad, and thermal conduction between the die and the third circuit board is implemented via the first pad and the second pad that are soldered.

11. The package assembly according to claim 9 or 10, wherein the third circuit board has a second thermal conduction sheet, and the first connection part and the second thermal conduction structure are both connected to the second thermal conduction sheet, to implement thermal conduction between the first connection part and the second thermal conduction structure via the second thermal conduction sheet.

12. The package assembly according to claim 11, wherein at least a part of the projection of the first connection part in the thickness direction of the first chip is located inside a projection of the second thermal conduction sheet in the thickness direction of the first chip; and
at least a part of a projection of the die in the thickness direction of the first chip is located inside the projection of the second thermal conduction sheet in the thickness direction of the first chip.

13. The package assembly according to claim 11 or 12, wherein the first connection part is disposed on a surface of the side that is of the third circuit board and that faces the second chip, and the second thermal conduction sheet is located at an inner layer of the third circuit board;
the first connection part is connected to the second thermal conduction sheet via a first thermal conduction body embedded in the third circuit board, to implement thermal conduction between the first connection part and the second thermal conduction sheet via the first thermal conduction body; and
the second thermal conduction structure is connected to the second thermal conduction sheet via a second thermal conduction body embedded in the third circuit board, to implement thermal conduction between the second thermal conduction structure and the second thermal conduction sheet via the second thermal conduction body.

14. The package assembly according to any one of claims 9 to 13, wherein a third thermal conduction structure is disposed on the surface of the side that is of the third circuit board and that faces the second chip, and a projection of the third thermal conduction structure in the thickness direction of the first chip is located inside the projection of the second chip in the thickness direction of the first chip.

15. The package assembly according to claim 14, wherein the third thermal conduction structure comprises a third pad disposed on a surface of the third circuit board and a solder ball disposed on a surface of the third pad; and
thermal conduction between the third circuit board and the solder ball disposed on the surface of the third pad is implemented via the third pad.

16. The package assembly according to any one of claims 1 to 15, wherein the first chip comprises a package structure;
at least a part of the die of the first chip is covered by the package structure; and
the thermal conduction pillar is disposed outside the package structure.

17. The package assembly according to any one of claims 1 to 8, wherein the first chip comprises a package structure;
at least a part of the die of the first chip is covered by the package structure; and
one side surface of the end that is of the thermal conduction pillar and that is connected to the first connection part is covered by the package structure.

18. The package assembly according to any one of claims 1 to 17, wherein the first chip is a logic chip or a system-on-chip, and the second chip is a storage chip.

19. An electronic device, comprising a first circuit board, a heat dissipation apparatus, and the package assembly according to any one of claims 1 to 18;
the package assembly is disposed between the first circuit board and the heat dissipation apparatus; and
one side that is of a first chip of the package assembly and that is away from a second chip of the package assembly is connected to the first circuit board, and the second chip and an end that is of a thermal conduction pillar of the package assembly and that is away from the first chip are both connected to the heat dissipation apparatus, to implement thermal conduction between the heat dissipation apparatus and both the thermal conduction pillar and the second chip.

20. The electronic device according to claim 19, further comprising a shielding cover, wherein
the shielding cover is mounted on the first circuit board, the heat dissipation apparatus is disposed on one side that is of the shielding cover and that is away from the first circuit board, and the shielding cover is connected to the heat dissipation apparatus, to implement thermal conduction between the shielding cover and the third circuit board the heat dissipation apparatus;
a mounting space is formed between the shielding cover and the first circuit board, and the first chip, the second chip, and the thermal conduction pillar are all disposed in the mounting space; and
the end that is of the thermal conduction pillar and that is away from the first chip is connected to the shielding cover, so that the thermal conduction pillar is connected to the heat dissipation apparatus via the shielding cover, to implement thermal conduction between the thermal conduction pillar and the heat dissipation apparatus via the shielding cover.

21. The electronic device according to claim 19, further comprising a shielding cover, wherein
the shielding cover is mounted on the first circuit board, and the heat dissipation apparatus is disposed on one side that is of the shielding cover and that is away from the first circuit board;
a mounting space is formed between the shielding cover and the first circuit board, and the first chip and the second chip are both disposed in the mounting space; and
the shielding cover has a through hole communicating the mounting space with the outside of the shielding cover, and the thermal conduction pillar passes through the through hole.

22. An electronic device, comprising a first circuit board, a heat dissipation apparatus, a package assembly, and a thermal conduction pillar, wherein
the package assembly and the thermal conduction pillar are both disposed between the first circuit board and the heat dissipation apparatus;
the package assembly comprises a first chip and a second chip, the second chip is disposed on one side of the first chip in a thickness direction, the other side of the first chip in the thickness direction is connected to the first circuit board, and one side that is of the second chip and that is away from the first chip is connected to the heat dissipation apparatus, to implement thermal conduction between the second chip and the heat dissipation apparatus;
the first circuit board has a third thermal conduction sheet, the third thermal conduction sheet has a third connection part and a fourth connection part, a projection of the third connection part in a thickness direction of the first circuit board is located outside a projection of the package assembly in the thickness direction of the first circuit board, and a projection of the fourth connection part in the thickness direction of the first circuit board is located inside a projection of the first chip in the thickness direction of the first circuit board; and
one end of the thermal conduction pillar is connected to the third connection part, to implement thermal conduction between the thermal conduction pillar and the third thermal conduction sheet; the other end of the thermal conduction pillar is connected to the heat dissipation apparatus, to implement thermal conduction between the thermal conduction pillar and the heat dissipation apparatus; and the fourth connection part is connected to the first chip, to implement thermal conduction between the third thermal conduction sheet and the first chip.

23. The electronic device according to claim 22, wherein one side that is of the first chip and that faces the first circuit board comprises a second electrical connection region, and a projection of the second electrical connection region in the thickness direction of the first circuit board is located outside a projection of the third thermal conduction sheet in the thickness direction of the first circuit board;
a second power terminal and a second signal terminal are disposed on the side that is of the first chip and that faces the first circuit board, the second power terminal and the second signal terminal are both located in the second electrical connection region, and the first chip is electrically connected to the first circuit board via the second power terminal and the second signal terminal; and
a fourth thermal conduction structure is disposed between the first chip and the fourth connection part, and the first chip is connected to the fourth connection part via the fourth thermal conduction structure, to implement thermal conduction between the first chip and the third thermal conduction sheet via the fourth thermal conduction structure.

24. The electronic device according to claim 23, wherein the third thermal conduction sheet is made of a conductive material, the fourth thermal conduction structure comprises a second ground terminal disposed on the side that is of the first chip and that faces the first circuit board, a projection of the second ground terminal in the thickness direction of the first circuit board is located inside the projection of the fourth connection part in the thickness direction of the first circuit board, and the first chip is electrically connected to the fourth connection part via the second ground terminal.

25. The electronic device according to any one of claims 22 to 24, wherein a surface of one side that is of the first circuit board and that is configured to mount the first chip has the third thermal conduction sheet.

26. The electronic device according to any one of claims 22 to 25, wherein the first chip comprises a third part and a fourth part, the third part comprises a first core, the fourth part comprises a second core, and power of the first core is higher than power of the second core; and
the projection of the fourth connection part in the thickness direction of the first circuit board is located inside a projection of the third part in the thickness direction of the first circuit board, and the projection of the fourth connection part in the thickness direction of the first circuit board is located outside a projection of the fourth part in the thickness direction of the first circuit board.

27. The electronic device according to any one of claims 22 to 26, further comprising a shielding cover, wherein
the shielding cover is mounted on the first circuit board, and the heat dissipation apparatus is disposed on one side that is of the shielding cover and that is away from the first circuit board;
a mounting space is formed between the shielding cover and the first circuit board, and the first chip and the second chip are both disposed in the mounting space; and
the thermal conduction pillar is disposed outside the shielding cover.

28. The electronic device according to any one of claims 22 to 27, wherein the first chip is a logic chip or a system-on-chip, and the second chip is a storage chip.
